(19) Europäisches Patentamt
European Patent Office
Office européen des brevets

(11) **EP 4 770 372 A1**

(12) **EUROPEAN PATENT APPLICATION**

(43) Date of publication:
**01.07.2026 Bulletin 2026/27**

(21) Application number: **25214893.7**

(22) Date of filing: **11.11.2025**

(51) International Patent Classification (IPC):
**H10K 59/124** (2023.01)    **H10K 59/80** (2023.01)

(52) Cooperative Patent Classification (CPC):
**H10K 59/878; H10K 59/124; H10K 59/879;**
H10K 59/80521

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **30.12.2024 KR 20240201445**

(71) Applicant: **LG Display Co., Ltd.**
**Seoul, 07336 (KR)**

(72) Inventors:
• **PARK, Hyemin**
  **Paju-si, 10845 (KR)**
• **KIM, Seungkyeom**
  **Paju-si, 10845 (KR)**
• **KIM, KyungMin**
  **Paju-si, 10845 (KR)**
• **KIM, Taehyeon**
  **Paju-si, 10845 (KR)**

(74) Representative: **Ter Meer Steinmeister & Partner**
**Patentanwälte mbB**
**Nymphenburger Straße 4**
**80335 München (DE)**

(54) **LIGHT EMITTING DISPLAY DEVICE**

(57)    A light emitting display device includes a substrate (100), a plurality of pixels, a first planarization layer (PL1), a second planarization layer 8PL2), an anode electrode (ANO), an emission layer (EL) and a cathode electrode (CAT). The plurality of pixels is arranged on the substrate (110). Each pixel has an emission area (EA) and a non-emission area (NEA). The first planarization layer (PL1) is disposed at the non-emission area (NEA) with a first refractive index on the substrate (110). The second planarization layer (PL2) is disposed at the emission area (EA) with a second refractive index higher than the first refractive index. The second planarization layer (PL2) is extruded upward from the first planarization layer (PL1). The anode electrode (ANO) is disposed on the second planarization layer (PL2) within the emission area (EA). The emission layer (EL) is disposed on the anode electrode (ANO) , the first planarization layer (PL1) and the second planarization layer (PL2). The cathode electrode (CAT) is disposed on the emission layer (EL).

FIG. 8

EP 4 770 372 A1

**Description**

This application claims the benefit of an earlier filing date and right of priority to Korean Patent Application No. 10-2024-0201445 filed on December 30, 2024.

TECHNICAL FIELD

The present disclosure generally relates to a light emitting display device.

BACKGROUND

Light emitting display devices are designed with a goal of achieving a wide viewing angle, excellent contrast, and fast response speed. The light emitting element used in a light emitting display device may have a light emitting layer made of organic or inorganic material arranged between an anode electrode and a cathode electrode.

In the light emitting element, holes are supplied from the anode electrode and electrons are supplied from the cathode electrode, and then the electrons and holes combine at the emission layer to generate excitons. As the excitons change from the excited state to the ground state, the fluorescent molecules in the emission layer may emit light to express color.

Some of the light emitted from the emission layer of the light emitting display device may not be emitted to the outside and may be lost due to total reflection within the electrode layer having a high refractive index, or due to total reflection occurring at the interface between the emission layer and the electrodes and/or the interface between the substrate and the air. This may result in a problem of reduced light extraction efficiency.

To overcome these problems and to improve the light extraction efficiency of light emitting devices, microlenses or microcavity structures can be implemented inside the devices. However, although these structures improve the luminous efficiency of light emitted in the vertical direction of the display device, they cannot extract light emitted in the horizontal direction to the vertical direction. Therefore, existing methods have limitations in improving overall light extraction efficiency.

SUMMARY

A light emitting display device according to an aspect of the present disclosure includes: a substrate, a plurality of pixels, a first planarization layer, a second planarization layer, an anode electrode, an emission layer and a cathode electrode. The plurality of pixels is arranged on the substrate. Each of the pixels has an emission area and a non-emission area. The first planarization layer is disposed at the non-emission area with a first refractive index on the substrate. The second planarization is disposed at the emission area with a second refractive index higher than the first refractive index. The second planarization layer is extruded upward from the first planarization layer. The anode electrode is disposed on the second planarization layer within the emission area. The emission layer is disposed on the anode electrode, the first planarization layer and the second planarization layer. The cathode electrode is disposed on the emission layer.

Implementations disclosed herein can provide various technical benefits. For example, the light emitting display device according to some implementations of the present disclosure may have a structure in which almost all of the lights emitted from the emission layer may be extracted to the outside without being trapped and extinguished inside of the device, thereby providing a bottom emission type light emitting display device with maximized light extraction efficiency.

The light emitting display device according to some implementations of the present disclosure may provide a bottom emission type light emitting display device that minimizes non-emission areas and improve light extraction efficiency by arranging micro mirrors (or reflectors) without using a bank covering the circumferences of the pixel electrode.

With the micro-mirror structure formed at the edge of the anode electrode, the light emitting display device according to some implementations of the present disclosure may further extract lights that would otherwise be lost within the light emitting diode (or, within the anode electrode). In particular, by implementing a structure in which lights that may be lost within the light emitting diode (or, within the anode electrode) in the central portion of the pixel may be also extracted to the outside, the light extraction efficiency may be further improved. Accordingly, the light emitting display device may provide higher brightness with the same power consumption, or may use lower power consumption to provide the same brightness. Therefore, the light emitting display device according to the present disclosure may be driven at low power consumption.

The effects that may be obtained from the present disclosure are not limited to the effects mentioned above, and other effects that are not mentioned may be clearly understood by those skilled in the art to which this disclosure belongs from the description above.

BRIEF DESCRIPTION OF THE DRAWINGS

FIG. 1 is a diagram illustrating an example of a schematic structure of a light emitting display device according to the present disclosure.

FIG. 2 is a circuit diagram illustrating a structure of one pixel included in the light emitting display device according to an example of the present disclosure.

FIG. 3 is a plan view illustrating an arrangement structure of the pixels arrayed in one unit-pixel of the light emitting display device according to an example of the present disclosure.

FIG. 4 is an enlarged cross-sectional view, taken along line I-I' in FIG. 3, for illustrating the structure of a light emitting display device according to an example of the present disclosure.

FIG. 5 is an enlarged cross-sectional view, taken along line II-II' in FIG. 3, for illustrating light paths in a light emitting display device according to an example of the present disclosure.

FIG. 6 is an enlarged cross-sectional view, taken along line II-II' of FIG. 3, illustrating an example of a structure of a light emitting display device according to a first implementation of the present disclosure.

FIG. 7 is an enlarged cross-sectional view, taken along line II-II' of FIG. 3, illustrating an example of a structure of a light emitting display device according to a second implementation of the present disclosure.

FIG. 8 is an enlarged cross-sectional view, taken along line II-II' of FIG. 3, illustrating an example of a structure of a light emitting display device according to a third implementation of the present disclosure.

FIG. 9 is a diagram illustrating an example of an optical path of a light at the interface between the first planarization layer and the second planarization layer of a light emitting display device according to a third implementation of the present disclosure.

FIG. 10 is a diagram illustrating an example of a relationship between the first planarization layer and the second planarization layer of a light emitting display device according to a third implementation of the present disclosure.

FIG. 11 is an enlarged cross-sectional view, taken along line II-II' of FIG. 3, illustrating an example of a structure of a light emitting display device according to a fourth implementation of the present disclosure.

FIG. 12 is an enlarged plan view illustrating an example of a structure of a light emitting display device according to a fifth implementation of the present disclosure.

FIG. 13 is an enlarged cross-sectional view, taken along line III-III' of FIG. 12, illustrating an example of a structure of a light emitting display device according to a fifth implementation of the present disclosure.

FIG. 14 is an enlarged cross-sectional view, taken along line III-III' of FIG. 12, illustrating an example of a structure of a light emitting display device according to a sixth implementation of the present disclosure.

FIG. 15 is an enlarged cross-sectional view, taken along line IV-IV' of FIG. 3, illustrating an example of a structure of a light emitting display device according to a seventh implementation of the present disclosure.

FIG. 16 is an enlarged cross-sectional view, taken along line IV-IV' of FIG. 3, illustrating an example of a structure of a light emitting display device according to a eighth implementation of the present disclosure.

DETAILED DESCRIPTION

Implementations of the present disclosure can provide a bottom emission type light emitting display device that enhances light extraction efficiency.

Implementations of the present disclosure can provide a bottom emission type light emitting display device that can improve light extraction efficiency by extracting light generated from the emission layer to the outside, which would otherwise be trapped inside the device and disappear due to total reflection.

Implementations of the present disclosure can provide a bottom emission type light emitting display device that improves brightness (or luminance) degradation rate and light extraction efficiency by arranging a micro mirror structure on the edge of the light emitting area to maximize the area of the light emitting area. In some implementations, a bottom emission type light emitting display device can improve light extraction efficiency and enhance brightness per power consumption by extracting light that may be extinguished by an electric field from the central portion of the anode electrode to the outside.

Advantages and features of the present disclosure, and implementation methods thereof will be described through various examples implementations described with reference to the accompanying drawings. The present disclosure may, however, be implemented in different forms and should not be construed as limited to the implementations set forth herein. Rather, these example implementations are provided so that this disclosure may be sufficiently thorough and complete to assist those skilled in the art to fully understand the scope of the present disclosure. Further, the protected scope of the present disclosure is defined by claims and their equivalents.

The shapes, sizes, ratios, angles, numbers, and the like, which are illustrated in the drawings in order to describe various example implementations of the present disclosure, are merely given by way of example. Therefore, the present disclosure is not limited to the illustrated details. Like reference numerals refer to like elements throughout the specification unless otherwise specified. In the following description, where the detailed description of the relevant known function or configuration may unnecessarily obscure an important point of the present disclosure, a detailed description of such known function of configuration may be omitted.

Reference will now be made in detail to the example implementations of the present disclosure, examples of which are illustrated in the accompanying drawings. Wherever possible, the same reference numbers will be used throughout the drawings to refer to the same or like parts. In the specification, it should be noted that like reference numerals already used to denote like elements in other drawings are used for elements wherever possible. In the following description, when a function and a configuration known to those skilled in the art are irrelevant to the essential configuration of the present disclosure, their detailed descriptions will be omitted. The terms described in the specification should be understood as follows.

In the present specification, where the terms "comprise," "have," "include," and the like are used, one or more other elements may be added unless the term, such as "only," is used. An element described in the singular form is intended to include a plurality of elements, and vice versa, unless the context clearly indicates otherwise.

In construing an element, the element is construed as including an error or tolerance range even where no explicit description of such an error or tolerance range is provided.

In the description of the various implementations of the present disclosure, where positional relationships are described, for example, where the positional relationship between two parts is described using "on," "over," "under," "above," "below," "beside," "next," or the like, one or more other parts may be located between the two parts unless a more limiting term, such as "immediate(ly)," "direct(ly)," or "close(ly)" is used. For example, where an element or layer is disposed "on" another element or layer, a third layer or element may be interposed therebetween. Also, if a first element is described as positioned "on" a second element, it does not necessarily mean that the first element is positioned above the second element in the figure. The upper part and the lower part of an object concerned may be changed depending on the orientation of the object. Consequently, where a first element is described as positioned "on" a second element, the first element may be positioned "below" the second element or "above" the second element in the figure or in an actual configuration, depending on the orientation of the object.

In describing a temporal relationship, when the temporal order is described as, for example, "after," "subsequent," "next," or "before," a case which is not continuous may be included unless a more limiting term, such as "just," "immediate(ly)," or "direct(ly)," is used.

It will be understood that, although the terms "first," "second," and the like may be used herein to describe various elements, these elements should not be limited by these terms as they are not used to define a particular order. These terms are used only to distinguish one element from another. For example, a first element could be termed a second element, and, similarly, a second element could be termed a first element, without departing from the scope of the present disclosure.

In describing various elements in the present disclosure, terms such as first, second, A, B, (a), and (b) may be used. These terms are used merely to distinguish one element from another, and not to define a particular nature, order, sequence, or number of the elements. Where an element is described as being "linked", "coupled," or "connected" to another element, that element may be directly or indirectly connected to that other element unless otherwise specified. It is to be understood that additional element or elements may be "interposed" between the two elements that are described as "linked," "connected," or "coupled" to each other.

To elaborate, as used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

It should be understood that the term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, and the third element.

Features of various implementations of the present disclosure may be partially or overall coupled to or combined with each other, and may be variously inter-operated with each other and driven technically as those skilled in the art can sufficiently understand. The implementations of the present disclosure may be carried out independently from each other, or may be carried out together in a co-dependent relationship.

Hereinafter, an example of a display apparatus according to the present disclosure will be described in detail with reference to the attached drawings. Wherever possible, the same reference numbers will be used throughout the drawings to refer to the same or like parts.

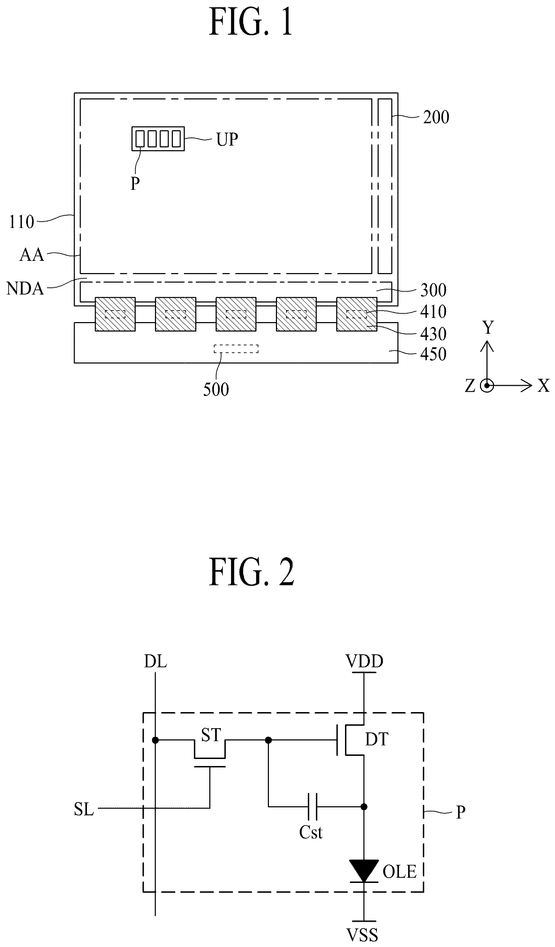

Hereinafter, referring to figures, various implementations of the present disclosure will be explained. FIG. 1 is a diagram illustrating an example of a schematic structure of a light emitting display device according to the present disclosure. In FIG. 1, the X-axis refers to the direction parallel to the scan line, the Y-axis refers to the direction of the data line, and the Z-axis refers to the height direction of the display device.

Referring to FIG. 1, the light emitting display device includes a substrate 110, a gate (or scan) driver 200, a pad portion 300, a source driving IC (Integrated Circuit) 410, a flexible circuit film 430, a circuit board 450, and a timing controller 500.

The substrate 110 may include an electrical insulating material or a flexible material. The substrate 110 may be made of a glass, a metal or a plastic, but it is not limited thereto. When the light emitting display device is a flexible display, the substrate 110 may be made of the flexible material such as plastic. For example, the substrate 110 may include a transparent polyimide material.

The substrate 110 may include a display area AA and a non-display area NDA. The display area AA, which is an area for representing the video images, may be defined as the majority middle area of the substrate 110, but it is not limited thereto. In the display area AA, a plurality of scan lines (or gate lines), a plurality of data lines and a plurality of unit pixels UP may be formed or disposed. The unit pixels UP are arrayed in a matrix manner. Each of unit pixels UP may include a plurality of pixels P. Each of pixels P includes the scan line and the data line, respectively.

The non-display area NDA, which is an area not representing the video images, may be defined at the circumference areas of the substrate 110 surrounding all or some of the display area AA. In the non-display area NDA, the gate driver 200 and the pad portion 300 may be formed or disposed.

The gate driver 200 may supply the scan (or gate) signals to the scan lines according to the gate control signal input through the pad portion 300 from the timing controller 500. The gate driver 200 may be formed at the non-display area NDA at any one outside of the display area AA on the substrate 110, as a GIP (Gate driver In Panel) type. GIP type means that the gate driver 200 is directly formed on the substrate 110. For example, the gate driver 200 may be configured as a shift resistor, and the GIP type refers to a structure in which transistors for the shift resistor of the gate driver 200 are directly formed on the substrate 110.

The pad portion 300 may supply data signals to data lines according to a data control signal input from the timing controller 500. The pad portion 300 may be formed as a driving chip and mounted the flexible circuit film 430. The flexible circuit film 430 may be attached to the non-display area NDA of one edge of the display area AA of the substrate 110.

The source driving IC 410 may receive the digital video data and the source control signal from the timing controller 500. The source driving IC 410 may convert the digital video data into the analog data voltages according to the source control signal and then supply that to the data lines. When the source driving IC 410 is made as a chip type, it may be installed on the flexible circuit film 430 as a COF (chip on film) or COP (chip on plastic) type.

The flexible circuit film 430 may include a plurality of first link lines connecting the pad portion 300 to the source driving IC 410, and a plurality of second link lines connecting the pad portion 300 to the circuit board 450. The flexible circuit film 430 may be attached on the pad portion 300 using an anisotropic conducting film, so that the pad portion 300 may be connected to the first link lines of the flexible circuit film 430.

The circuit board 450 may be attached to the flexible circuit film 430. The circuit board 450 may include a plurality of circuits implemented as the driving chips. For example, the circuit board 450 may be a printed circuit board or a flexible printed circuit board. The circuit board 450 may be a printed circuit board or a flexible printed circuit board.

The timing controller 500 may receive the digital video data and the timing signal from an external system board through the line cables of the circuit board 450. The timing controller 500 may generate a gate control signal for controlling the operation timing of the gate driver 200 and a source control signal for controlling the source driving IC 410, based on the timing signal. The timing controller 500 may supply the gate control signal to the gate driver 200 and supply the source control signal to the source driving IC 410. Depending on the product types, the timing controller 500 may be formed as one chip with the source driving IC 410 and mounted on the substrate 110.

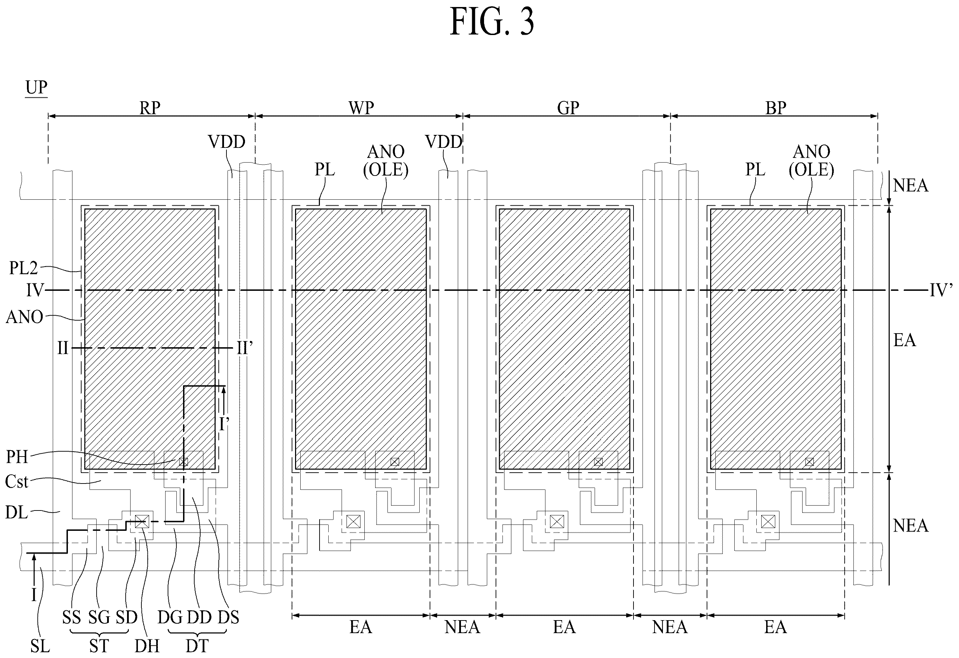

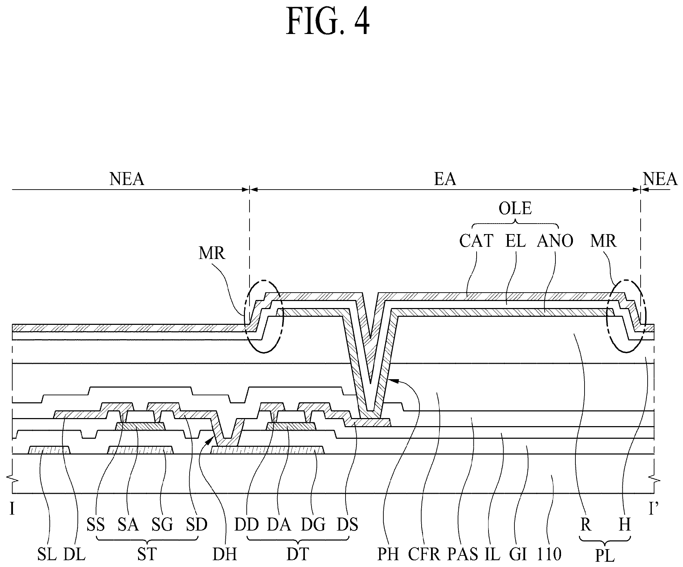

Hereinafter, referring to Figs. 2 to 4, an implementation of the present disclosure will be explained. FIG. 2 is a circuit diagram illustrating a structure of one pixel included in the light emitting display device according to an example of the present disclosure. FIG. 3 is a plan view illustrating an arrangement structure of the pixels arrayed in a unit-pixel of the light emitting display device according to an example of the present disclosure. FIG. 4 is an enlarged cross-sectional view along to cutting line I-I' in FIG. 3, for illustrating the structure of a light emitting display device according to an example of the present disclosure.

Referring to Figs. 2 to 4, a light emitting display device includes a plurality of unit pixels P in a matrix arrangement. Each unit pixel UP of the light emitting display may include three pixels P or four pixels P. For example, one unit pixel P may include a red pixel RP, a green pixel GP and a blue pixel BP. For another example, as shown in FIG. 3, one unit pixel UP may include one red pixel RP, a white pixel WP, a green pixel GP, and a blue pixel BP.

One pixel P of the light emitting display device, i.e., any one among red pixel RP, white pixel WP, green pixel GP and blue pixel BP, may be defined by a scan line SL, a data line DL and a driving current line VDD. A pixel P may include an emission area EA and a non-emission area NEA. The emission area EA may be an area providing light emissions for representing video and/or picture image. The non-emission area NEA may be an area not providing any light emissions. In any one pixel of the light emitting display device may include a switching thin film transistor ST, a driving thin film transistor DT, a light emitting diode OLE, and a capacitance Cst. The driving current line VDD may be supplied with a high-level voltage for driving the light emitting diode OLE.

In the following description referring to FIG. 3, one pixel P is explained as having a data line DL at the left side and a driving current line VDD at the right side. However, it is not limited thereto. The structure of pixel P may be implemented in various forms. For example, one unit-pixel including four pixels P, the driving current lines VDD may be disposed, respectively, at left side and right side of the unit pixel UP. Further, a reference line (not shown in figures) may be disposed between a white pixel WP and a green pixel GP. In addition, a data line DL may be disposed at each left side of each of the pixels P.

The switching thin film transistor ST may be disposed at a location where the scan line SL and the data line DL intersect. The switching thin film transistor ST may include a gate electrode SG, a semiconductor layer SA, a source electrode SS and a drain electrode SD. The gate electrode SG may be connected to the scan line SL. The source electrode SS may be connected to the data line DL, and the drain electrode SD may be connected to the driving thin film transistor DT. The semiconductor layer SA may be disposed on a gate insulating layer GI as overlapping with the gate electrode SG. The portion of the semiconductor layer SA overlapping the gate electrode SG may be defined as a channel region.

An intermediate insulating layer IL may be deposited on the semiconductor layer SA. The source electrode SS and the drain electrode SD may be formed on the intermediate insulating layer IL. The source electrode SS may be connected to one side of the semiconductor layer SA via one contact hole formed at the intermediate insulating layer IL. The drain electrode SD may be connected to another side of the semiconductor layer SA via another contact dhole formed at the intermediate insulating layer IL. The switching thin film transistor ST may select a pixel P to be driven by applying a data signal to the driving thin film transistor DT.

The driving thin film transistor DT may drive the light emitting diode OLE of the pixel selected by the switching thin film transistor ST. The driving thin film transistor DT may include a gate electrode DG, a semiconductor layer DA, a source electrode DS and a drain electrode DD. The gate electrode DG of the driving thin film transistor DT may be connected to the drain electrode SD of the switching thin film transistor ST. For example, the gate electrode DG of the driving thin film transistor DT may be connected to the drain electrode SD of the switching thin film transistor ST via a drain contact hole DH penetrating the gate insulating layer GI covering the gate electrode DG. The drain electrode DD may be connected to the driving current line VDD, and the source electrode DS may be connected to an anode electrode ANO of the light emitting diode OLE. The capacitance Cst may be disposed between the gate electrode DG of the driving thin film transistor DT and the anode electrode ANO of the light emitting diode OLE.

The intermediate insulating layer IL may be deposited on the semiconductor layer DA. The source electrode DS and the drain electrode DD may be formed on the intermediate insulating layer IL. The source electrode DS may be connected to one side of the semiconductor layer DA via one contact hole formed at the intermediate insulating layer IL. The drain electrode DD may be connected to another side of the semiconductor layer DA via another contact hole formed at the intermediate insulating layer IL.

The driving thin film transistor DT may be disposed between the driving current line VDD and the light emitting diode OLE. The driving thin film transistor DT may control the amount of current flowing from the driving current line VDD to the light emitting diode OLE according to the magnitude of the voltage of the gate electrode DG connected to the drain electrode SD of the switching thin film transistor ST.

The light emitting diode OLE may include an anode electrode ANO, an emission layer EL and a cathode electrode CAT. The light emitting diode OLE may emit lights in response to an electric current controlled by the driving thin film transistor DT. In detail, since the amount of light emitted may be adjusted according to the current controlled by the driving thin film transistor DT, the brightness of the light emitting display device may be controlled. The anode electrode ANO of the light emitting diode OLE may be connected to the source electrode DS of the driving thin film transistor DT, and the cathode electrode CAT may be connected to a low voltage line VSS to which a low potential voltage is applied. The light emitting diode OLE may be driven by the difference between a low-potential voltage and a high-potential voltage controlled by a driving thin film transistor DT.

A passivation layer PAS is deposited on the surface of the substrate 110 having the thin film transistors ST and DT. The passivation layer PAS may include an inorganic material such as silicon oxide (SiOx) or silicon nitride (SiNx). The thin layers configuring the thin film transistors ST and DT formed on the substrate 110 may be called as a 'driving element layer.' For example, from a metal layer of the scan line SL and the gate electrodes SG and DG to the passivation layer PAS covering the thin film transistors ST and DT may be defined as the driving element layer.

A color filter CF may be formed on the passivation layer PAS. The color filter CF may be disposed on each pixel P. For example, the color filter may include a red color filter CFR disposed at the red pixel RP, a green color filter CFG disposed at the green pixel GP, and a blue color filter CFB disposed at the blue pixel BP. Color filter may not be disposed at the white pixel WP.

In FIG. 4, the color filter CF is described as having a structure that extends from the emission area EA to the non-emission area NEA. However, it is not limited thereto, the color filter CF may be formed as corresponding to each of the emission areas EA.

A planarization layer PL may be deposited on the color filter CF. The planarization layer PL may be a thin film for making the surface of the substrate 110 on which thin film transistors ST and DT are formed flat. To make even the height difference, the planarization layer PL may be formed of an organic material.

A pixel contact hole PH for exposing a portion of the source electrode DS of the driving thin film transistor DT may be formed as penetrating the passivation layer PAS, the color filter CF and the planarization layer PL. An anode electrode ANO may be formed on the planarization layer PL. The anode electrode ANO may be connected to the source electrode DS of the driving thin film transistor DT via the pixel contact hole PH.

The planarization layer PL may have a level difference. For example, the planarization layer PL may be patterned using an anode electrode ANO as a mask. As a result, the planarization layer PL may have a structure in which the planarization layer PL may protrude upward, and the anode electrode ANO is formed on the protruded planarization layer PL. FIG. 4 shows an example where the protrusion portion R of the planarization layer PL is formed as covering the pixel contact hole PH. However, implementations are not limited thereto, and the protrusion portion R of the planarization layer PL may not cover the pixel contact hole PH. In this case, the circumferential portions of the pixel contact hole PH may be included in the non-emission area NEA.

The anode electrode ANO may have different material depending on the emission type of the light emitting diode OLE. For the bottom emission type in which the light emitting diode OLE emits toward the substrate 110, the anode electrode ANO may be formed of a transparent conductive material. For the top emission type in which the light emitting diode OLE emits upward opposing the substrate 110, the anode electrode ANO may be formed of a metal material having excellent light reflectance. In this case, the anode electrode ANO may have a structure in which a transparent conductive layer and a metal layer are stacked.

For the bottom emission type, the anode electrode ANO may be made of a transparent conductive material (TCO) or semi-transparent conductive material. For instance, the anode electrode ANO may be made of a transparent conductive material such as indium tin oxide (ITO), indium zinc oxide (IZO) or indium zinc tin oxide (IZTO). Otherwise, the anode electrode ANO may be made of a semi-transparent layer of magnesium (Mg), silver (Ag) or an alloy of magnesium (Mg) and silver (Ag) with a thickness of less than 100nm. The anode electrode ANO may be called as a first electrode or a transparent electrode.

An emission layer EL may be deposited on the anode electrode ANO. In some implementations, the emission layer EL may be disposed on the entire surface of the substrate 110 as one sheet type covering continuously the upper surface of the substrate 110. The emission layer EL may include various functional layers stacked each other. For example, the emission layer EL may include a hole functional layer, an organic emission layer, an electron functional layer. Each of the hole functional layer and the electron functional layer may be deposited on the substrate 110 as continuous sheet type. The organic emission layer may have a sheet shape between the hole functional layer and the electron functional layer. However, implementations are not limited thereto. The organic emission layer may be disposed as separated as corresponding to each emission area EA of each pixel P.

In addition, the emission layer EL may include two or more emission portions for emitting white color light. For example, the emission layer EL may have a tandem structure in which a first emission layer and a second emission layer are vertically stacked for emitting white color light by mixing a first color light and a second color light. However, implementations are not limited thereto, and the vertically stacked emission portions may include three or four layers.

A cathode electrode CAT may be deposited on the emission layer EL. In some implementations. the cathode electrode CAT may be disposed as a thin layer shape continuously spread on the entire surface of the substrate 110. The stacked structure of the anode electrode ANO, the emission layer EL and the cathode electrode CAT may configure the light emitting diode OLE.

The cathode electrode CAT may be made of a metal material having excellent light reflectance. For example, the cathode electrode CAT may be formed of a metal material with excellent light reflectance with a thickness of at least 2,000 Å to 3,000 Å (200nm to 300nm). For example, the metal material having excellent light reflectance may include aluminum (Al), magnesium (Mg), calcium (Ca), silver (Ag) or alloy of them (i.e., aluminum-magnesium alloy (AlMg)) As another example, the cathode electrode CAT may include thin metal layer having high reflectance such as stack of aluminum and titanium (Ti/Al/Ti), stack of aluminum and indium tin oxide (ITO/Al/ITO), silver alloy, or stack of silver alloy and indium tin oxide (ITO/Ag alloy/ITO). Here, silver alloy may be an alloy of silver (Ag), palladium (Pd) and copper (Cu). The cathode electrode CAT may be referred to as a second electrode, reflection electrode, or counter electrode.

The stacked structure of the anode electrode ANO, the emission layer EL and the cathode electrode CAT may configure the light emitting diode OLE. The light emitting display device according to implementations of the present disclosure may have a structure in which each of light emitting diode OLE is disposed on the planarization layer PL patterned with protruding island shape within the pixel P. The elements from the planarization layer PL deposited on the driving element layer to the cathode electrode CAT of the light emitting diode OLE may be collectively referred to as a 'light emitting element layer.'

As a detailed example, within each pixel P, a planarization layer PL is applied over the entire surface of the substrate 110, and has a protruding portion in the shape of an island with a certain thickness. The anode electrode ANO is formed on the upper surface of the protruding portion of the planarization layer PL. The emission layer EL may be deposited to cover the upper surface of the planarization layer PL (which has steps) and the upper surface of the anode electrode ANO. The cathode electrode CAT may be also deposited with the same profile as the emission layer EL. As a result, the cathode electrode CAT may have a cap, '∩', shape facing downward. Since the cathode electrode CAT may be made of a metal material with excellent light reflectance, the cathode electrode CAT may have a structure that forms cap shaped micro mirrors along the protruding portion of the planarization layer PL.

In the case of the bottom emission type, there may be a disadvantage in that the area ratio of the aperture area to the pixel area may be relatively smaller than a top emission type, due to the thin film transistor ST and DT, capacitance Cst, the scan line SL, the data line DL and the driving current line VDD. The light emitting display device according to implementations of the present disclosure may provide a structure equipped with a micro mirror so that light generated from the emission layer may be provided toward the substrate 110 placed underneath without loss even though the aperture area is small.

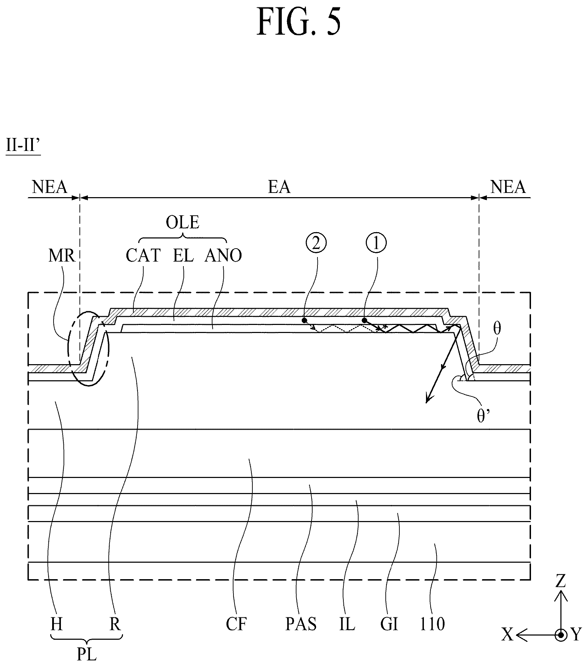

Hereinafter, referring to FIG. 5, an example of the mechanism for enhancing the light extraction efficiency by the micro mirror will be explained. FIG. 5 is an enlarged cross-sectional view along to cutting line II-II' in FIG. 3, for illustrating light paths in a light emitting display device according to an example of the present disclosure.

Referring to FIG. 5, a description is provided for the optical path ① for light emitted from the emission layer EL at the edge region of the anode electrode ANO. Lights emitted from the emission layer EL may be transmitted as a spherical wave. Lights may be emitted in all directions (360 degrees) from the cross-sectional view. Among the lights, the light emitted to the top direction may be reflected by the cathode electrode CAT and travel downward. That is, most of all lights generated from the emission layer EL may be radiated in a 180-degree range in a downward direction. These lights may be incident into the anode electrode ANO. Since the anode electrode ANO is made of a transparent conductive material, a portion, such as 60% to 70%, of the lights may pass through the anode electrode ANO, then pass through the color filter CF placed underneath, and then be emitted outside the substrate 110.

In some implementations, the anode electrode ANO may be a transparent conductive material with a refractive index of 2.0 to 2.3. The upper surface of the anode electrode ANO is in contact with the emission layer EL, and the bottom surface is in contact with the planarization layer PL. In some implementations, the emission layer EL and the planarization layer PL may have a refractive index of 1.3 to 1.5. As a result, a structure may be formed in which an anode electrode ANO with a high refractive index is interposed between two low refractive layers. Therefore, among the lights incident into the anode electrode ANO, a portion, such as 30% to 40%, of the lights corresponding to the total reflection condition may be propagated in the horizontal direction (X-axis direction) inside the anode electrode ANO.

According to the material of the emission layer EL, the refractive index of the emission layer EL may be similar to the refractive index of the anode electrode ANO. In this case, among the lights emitted from the emission layer EL, the lights totally reflected at the interface between the anode electrode ANO and the planarization layer PL may be trapped between the cathode electrode CAT and the planarization layer PL, so these lights may propagate in the horizontal direction (X-axis direction).

Lights propagating horizontally within the anode electrode ANO, or between the cathode electrode CAT and the planarization layer PL may be emitted from the end of the anode electrode ANO and be reflected by the cathode electrode CAT having the micro mirror structure to go downward. When there is no micro mirror structure formed by the protrusion of the planarization layer PL, the lights may be propagated horizontally and extinguished. However, according to the structure of implementations disclosed herein, the lights can be extracted downward by the micro mirror formed by the cathode electrode CAT, thereby improving the light extraction efficiency.

The above description explained that light propagating in the horizontal direction may propagate while repeating the total reflection process inside the anode electrode ANO. However, implementations are not limited thereto. The lights propagating in the horizontal direction may propagate while repeating the total reflection process inside the element including the anode electrode ANO and emission layer EL, i.e., between the cathode electrode CAT and the planarization layer PL. For convenience, in this disclosure, description if provided for scenarios where the light is totally reflected inside the light emitting diode OLE and propagates in the horizontal direction,

In some implementations, in order to ensure that the lights reflected by the cathode electrode CAT having a micro mirror structure may be emitted to the downward direction properly, there may be adjustment of the angle of the inclination of the cathode electrode CAT deposited on the etched side where the step of the planarization layer PL is formed. For example, the angle θ of the inclined surface of the cathode electrode CAT with respect to the horizontal surface of the substrate 110 may be in the range of 50 degrees to 80 degrees. Since the cathode electrode CAT is deposited along the step shape of the planarization layer PL, the inclination angle θ of the cathode electrode CAT may be substantially equal to the side wall inclination angle θ' of the protrusion R in the planarization layer PL. Therefore, in some implementations, the inclination angle θ' is formed between the flat portion H and the protrusion portion R of the planarization layer PL to be 50 degrees to 80 degrees.

The light emitting display device according to some implementations of the present disclosure may include the cathode electrode CAT having the micro mirror structure according to the shape of the planarization layer PL having a protrusion portion R extruded as an island from the flat portion H. Therefore, the light extraction efficiency may be improved by extracting the light that may otherwise be extinguished inside the light emitting diode OLE among the lights generated from the emission layer EL.

Here, for convenience of explanation, description is provided based on one pixel, in which the planarization layer PL is described as a structure in which a protrusion portion R protrudes from the flat portion H. However, in some implementations, a large number of pixels cam be arranged in a matrix manner, in which case the planarization layer PL can have a structure in which multiple protrusion portions R and multiple depression portions (corresponding to multiple flat portions H) are repeatedly arranged. That is, the flat portion H may be called a depression portion. In this case, the protrusion portions R may correspond to the emission areas within each pixel, and the depressed portions (flat portions H) may correspond to the non-emission areas surrounding the emission areas.

The light emitting display having the micro mirror structure described above may extract the lights that would otherwise be trapped and extinguished within the anode electrode ANO to the outside of the anode electrode ANO. However, the lights emitted from the emission layer EL at the central region of the anode electrode ANO, in the plan view, may not be extracted to the outside.

Hereinafter, description is provided of the optical path ② for light emitted from the emission layer EL at the central region of the light emitting diode OLE on the plan view. Lights generated from the emission layer EL may be radiated in a 180 degree range downward by the same mechanism as described above. Since the anode electrode ANO is made of a transparent conductive material, a portion, such as 60% to 70%, of the lights may pass through the anode electrode ANO, then pass through the color filter CF placed underneath, and then be emitted outside the substrate 110.

However, among the lights incident into the anode electrode ANO, a portion, such as 30% to 40%, of the lights that meet the total reflection condition may be propagated in the horizontal direction (X-axis direction) inside the anode electrode ANO (or, inside the light emitting diode OLE). In particular, the lights generated at the central region of the pixel may undergo a total reflection process inside the anode electrode ANO, so that the length of the propagating optical path ② may be much longer than the length of the optical path ① described above. Therefore, light traveling along the propagating optical path ② may be dissipated as heat energy inside the anode electrode ANO before being emitted through the end of the anode electrode ANO. In general, when lights propagate over a length of 20 $\mu$m or more inside the anode electrode ANO, the lights may be extinguished or annihilated.

Hereinafter, various implementations of the present disclosure, in which lights emitted from an emission layer EL in the middle portion (in a plan view) of the light emitting diode OLE in a light emitting display device may be extracted to the outside before being lost or extinguished.

In the following explanation, descriptions for the driving element layer which are common to different figures will not be duplicated. Further, the configuration of the driving element layer is not limited to the examples of Figs. 2 to 4. The configuration of the thin film transistors ST and DT may have any one structure of top gate structure, bottom gate structure and double gate structure. The thin film transistors ST and DT may include oxide semiconductor material. For example, the material for the semiconductor layers SA and DA may include a metal oxide material such as indium gallium zinc oxide (IGZO). However, it is not limited thereto, and the semiconductor layers SA and DA may include any one of an amorphous silicon (a-Si), a polycrystalline silicon (Poly Si), or a low temperature polycrystalline silicon (LTPS).

In addition, the arrangement of the signal lines including scan line SL, data line DL and driving current line VDD may be varied. Other signal lines including reference lines may be further included. In the following description, drawing numeric symbols which are shown in the drawings but not explained may be referred to the description of the drawing numeric symbols in Figs. 2 to 4.

<First Implementation>

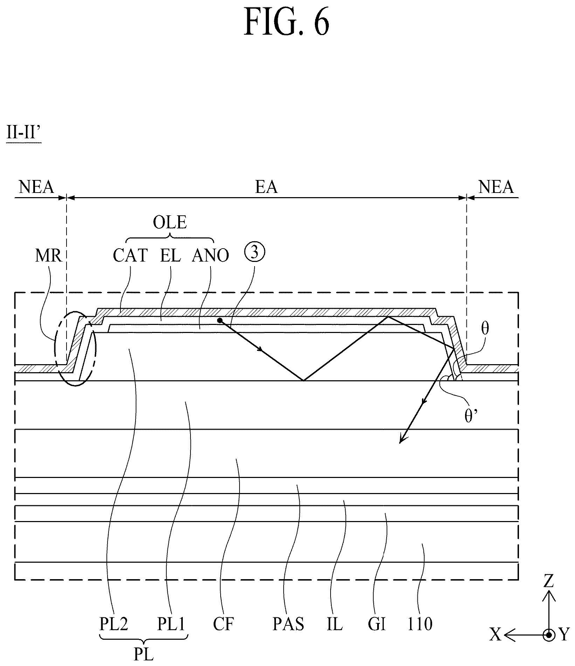

Hereinafter, referring to the example of FIG. 6, description will be provided of a structure of a light emitting display device according to a first implementation of the present disclosure. FIG. 6 is an enlarged cross-sectional view, taken along line II-II' of FIG. 3, illustrating an example structure of a light emitting display device according to a first implementation of the present disclosure.

Referring to FIG. 6, a pixel P may include an emission area EA and a non-emission area NEA. In FIG. 6, the emission area EA may include the micro-mirror MR and the light emitting diode OLE. The area outside the emission area EA may be the non-emission area NEA.

Referring to FIG. 6, a gate insulating layer GI, an intermediate insulating layer IL and a passivation layer PAS may be sequentially stacked on a substrate 110. A color filter CF may be disposed on the passivation layer PAS. A planarization layer PL may be disposed on the color filter CF. The planarization layer PL may include a first planarization layer PL1 and a second planarization layer PL2 sequentially stacked. The first planarization layer PL1 may be deposited on the color filter CF as covering entire surface of the substrate 110 with a predetermined thickness. The second planarization layer PL2 may be formed as an island shape only at a location corresponding to the emission area where the anode electrode ANO is disposed within a pixel P. That is, the second planarization layer PL2 may have an island shape protruding or extracting on the first planarization layer PL1.

In some implementations, the sidewall inclined angle θ' of the second planarization layer PL2 having a protruded shape (or island shape) on the first planarization layer PL1 may be the same as the sidewall inclined angle θ' described with FIG. 5. Similarly, the inclined angle θ of the cathode electrode CAT deposited on the first planarization layer PL1 and the second planarization layer PL2 may be substantially the same as the sidewall inclined angle θ' of the second planarization layer PL2 described with FIG. 5.

The first implementation may have a feature in which the second planarization layer PL2, which is in contact with the anode electrode ANO, may include a transparent organic material having refractive index that is the same as or at most 0.2 lower than the refractive index of the anode electrode ANO. This can have the technical effect of reducing the amount of lights lost by the total reflection process inside the anode electrode ANO(or, light emitting diode OLE).

For example, the anode electrode ANO may have a refractive index of 2.0 to 2.3. The second planarization layer PL2 may have a refractive index of 1.8 to 2.0, which is the same as or about 0.2 different from the refractive index of the anode electrode ANO. Meanwhile, the first planarization layer PL1 may have a refractive index of 1.3 to 1.5, which is at least 0.5 lower than that of the second planarization layer PL2.

In this case, the light emitted from the emission layer EL may propagate along light path ③ in FIG. 6. Lights generated from the emission layer EL may be radiated in a 180 degree range downward by the same mechanism as described above. Since the anode electrode ANO is made of a transparent conductive material and the second planarization layer PL2 has a similar refractive index with the anode electrode ANO, a larger portion, such as 90% to 98%, of the lights may pass through the anode electrode ANO and through the second planarization layer PL2. The lights passing through the second planarization layer PL2 may enter into the first planarization layer PL1. As the first planarization layer PL1 has a refractive index of 1.4 to 1.5, a portion, such as 60% to 70%, of the incident lights into the first planarization layer PL1 may pass through the first planarization layer PL1, and may pass through the color filter CF placed underneath, and then be emitted outside the substrate 110.

However, among the lights passing through the second planarization layer PL2, a portion, such as 30% to 40%, of the lights that meet the total reflection condition at the interface between the second planarization layer PL2 and the first planarization layer PL1 may be re-entered into the anode electrode ANO, and then may be totally reflected at the upper surface of the anode electrode ANO or reflected by the cathode electrode CAT.

According to light path ③ shown in FIG. 6, unlike the light paths ① and ② shown in FIG. 5, the space where light emitted from the emission layer EL is totally reflected may be expanded, and the number of iterations of total reflection may be significantly reduced, due to the second planarization layer PL2 having a thickness of 1~1.5 μm. As a result, most of the lights emitted from the middle portion of the pixel and totally reflected may be reflected by the cathode electrode CAT having the micro-mirror structure MR and then may be directed in a downward direction.

The light emitting display device according to the first implementation may extract almost all of the lights generated from the emission layer EL, due to the second planarization layer PL protruded as an island shape and the cathode electrode CAT having the micro-mirror structure formed by the shape of the second planarization layer PL2. Accordingly, the light extraction efficiency may be further increased, as compared to the structure shown in FIG. 5. In particular, since the second planarization layer PL2 may have a refractive index which is the same as the anode electrode ANO or slightly lower than the anode electrode ANO, the amount of the lights that may be trapped and lost inside the light emitting diode OLE may be reduced, so the light extraction efficiency may be enhanced. Further, the first planarization layer PL1 disposed under the second planarization layer PL2 may have low refractive index, so that the lights reflected from the first planarization layer PL1 may be reflected by the micro-mirror structure and then extracted outside. Therefore, the luminance at viewing angle may be enhanced.

<Second Implementation>

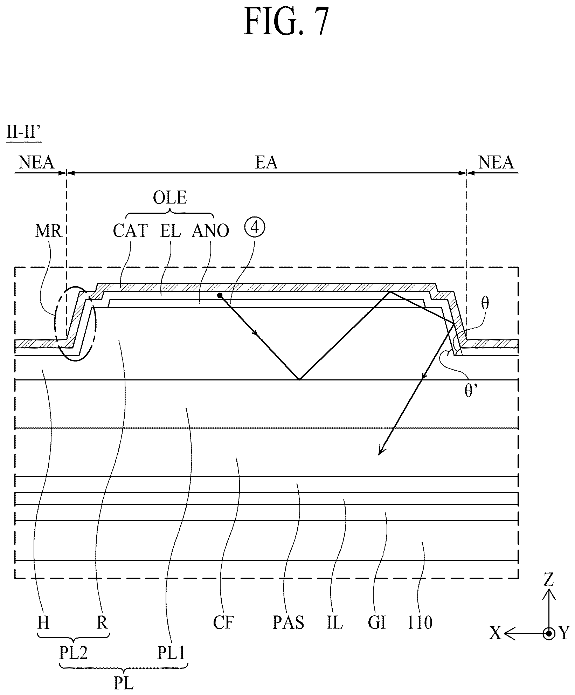

Hereinafter, referring to FIG. 7, a structure of the light emitting display device according to a second implementation will be explained. FIG. 7 is an enlarged cross-sectional view, taken along line II-II' of FIG. 3, illustrating an example of a structure of a light emitting display device according to a second implementation of the present disclosure.

The structure of a light emitting display device shown in FIG. 7 may be similar to that of the first implementation. However, a difference is that, for the second implementation, the second planarization layer PL2 may be deposited on the entire surface of the substrate 110 as covering the first planarization layer PL1. The second planarization layer PL2 may include a flat portion H and a protrusion portion R.

Referring to FIG. 7, a pixel P may include an emission area EA and a non-emission area NEA. In FIG. 7, the area including the micro-mirror MR and the light emitting diode may be the emission area EA. The area outside the emission area EA may be the non-emission area NEA.

A gate insulating layer GI, an intermediate insulating layer IL and a passivation layer PAS may be sequentially stacked on the substrate 110. A color filter CF may be deposited on the passivation layer PAS. A planarization layer PL may be deposited on the color filter CF. The planarization layer PL may include a first planarization layer PL1 and a second planarization layer PL2 sequentially stacked. The first planarization layer PL1 may be deposited on the color filter with a predetermined thickness as covering entire surface of the substrate 110. The second planarization layer PL2 may be deposited on the first planarization layer PL1. In particular, the second planarization layer PL2 may include a flat portion H and a protrusion portion R. The flat portion H may be corresponding to the non-emission area NEA surrounding the anode electrode ANO in the pixel P. The protrusion portion R may be corresponding to the emission area EA where the anode electrode ANO is placed in the pixel P.

Here, the sidewall inclined angle θ' of the protrusion portion R which is extruded upward from the flat portion H of the second planarization layer PL2 stacked on the first planarization layer PL1 may be the same as the sidewall inclined angle θ' described with FIG. 5. Similarly, the inclined angle θ of the cathode electrode CAT deposited on the second planarization layer PL2 may be substantially the same as the sidewall inclined angle θ' of the second planarization layer PL2.

The second implementation may have a feature in which the second planarization layer PL2 in contact with the anode electrode ANO may include a transparent organic material having refractive index that is the same as or at most 0.2 lower than the refractive index of the anode electrode ANO. This can have the technical effect of reducing the amount of lights lost by the total reflection process inside the anode electrode ANO or the light emitting diode OLE.

For example, the anode electrode ANO may have a refractive index of 2.0 to 2.3. The second planarization layer PL2 may have a refractive index of 1.8 to 2.0, which is the same as or about 0.2 different from the refractive index of the anode electrode ANO. Meanwhile, the first planarization layer PL1 may have a refractive index of 1.3 to 1.5, which is at least 0.5 lower than that of the second planarization layer PL2.

In this case, the light emitted from the emission layer EL may propagate with a manner of light path ④ in FIG. 7. A larger portion, such as 90% to 98%, of the lights generated from the emission layer EL may pass through the anode electrode ANO and the second planarization layer PL2. The lights passing through the second planarization layer PL2 may enter into the first planarization layer PL1. As the first planarization layer PL1 has a refractive index of 1.4 to 1.5, a portion, such as 60% to 70%, of the incident lights into the first planarization layer PL1 may pass through the first planarization layer PL1, then may pass through the color filter CF placed underneath, and then be emitted outside the substrate 110.

However, among the lights passing through the second planarization layer PL2, a portion, such as 30% to 40%, of the lights that meet the total reflection condition at the interface between the second planarization layer PL2 and the first planarization layer PL1 may be re-entered into the anode electrode ANO, and then reflected by the cathode electrode CAT. According to light path ④ shown in FIG. 7, unlike the light paths ① and ② shown in FIG. 5, the space where light emitted from the emission layer EL is totally reflected may be expanded, and the number of iterations of total reflection may be significantly reduced, due to the second planarization layer PL2 having a thickness of 1~1.5 μm. As a result, most of the lights emitted from the middle portion of the pixel and totally reflected may be reflected by the cathode electrode CAT having the micro-mirror structure MR and then may be directed in a downward direction.

The light emitting display device according to the second implementation may extract almost all of the lights generated from the emission layer EL, due to the second planarization layer PL having the protrusion portion R and the cathode electrode CAT having the micro-mirror structure formed by the shape of the second planarization layer PL2. Accordingly, the light extraction efficiency may be further increased. In particular, since the second planarization layer PL2 may have a refractive index which is the same as the anode electrode ANO or slightly lower than the anode electrode ANO, the amount of the lights that may be trapped and lost inside the light emitting diode OLE may be reduced, so the light extraction efficiency may be enhanced. Further, the first planarization layer PL1 disposed under the second planarization layer PL2 may have low refractive index, so that the lights reflected from the first planarization layer PL1 may be reflected by the micro-mirror structure and then extracted outside. Therefore, the luminance at viewing angle may be enhanced.

<Third Implementation>

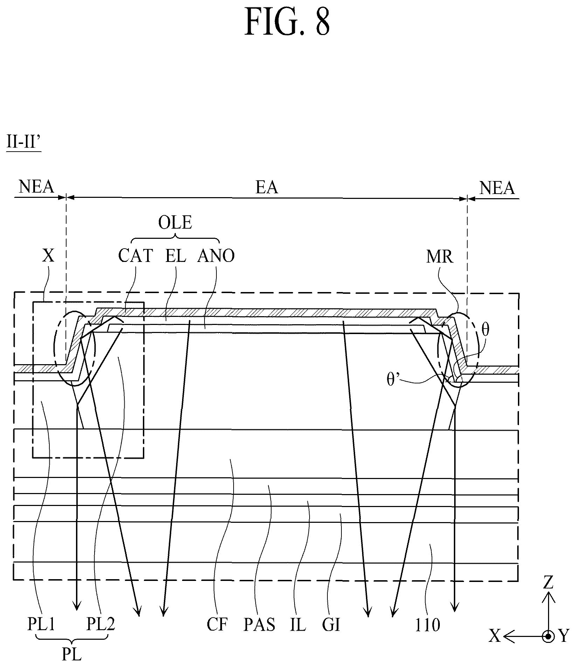

Hereinafter, referring to FIG. 8, an example of a structure of the light emitting display device according to a third implementation will be explained. FIG. 8 is an enlarged cross-sectional view, taken along line II-II' of FIG. 3, illustrating an example of a structure of a light emitting display device according to a third implementation of the present disclosure.

Referring to FIG. 8, a pixel P may include an emission area EA and a non-emission area NEA. In FIG. 8, the area including the micro-mirror MR and the light emitting diode may be the emission area EA. The area outside the emission area EA may be the non-emission area NEA.

A gate insulating layer GI, an intermediate insulating layer IL and a passivation layer PAS may be sequentially stacked on the substrate 110. A color filter CF may be deposited on the passivation layer PAS. A planarization layer PL may be deposited on the color filter CF.

The planarization layer PL may include a first planarization layer PL1 and a second planarization layer PL2. The first planarization layer PL1 may be disposed at the area in the pixel P where the anode electrode ANO (or the light emitting diode OLE) is not placed. Meanwhile, the second planarization layer PL2 may be disposed at an area where the anode electrode ANO (or, the light emitting diode OLE). The second planarization layer PL2 may have a shape extruded on the upper surface of the first planarization layer PL1. That is, the upper surface of the second planarization layer PL2 may be positioned at a location higher than the upper surface of the first planarization layer PL1. In other words, the second planarization layer PL2 may have a thickness thicker than that of the first planarization layer PL1. For example, the first planarization layer PL1 may correspond to the flat portion H shown in FIG. 5, and the second planarization layer PL2 may be correspond to the protrusion portion R shown in FIG. 5.

An anode electrode ANO may be disposed on the upper surface of the second planarization layer PL2. An emission layer EL may be deposited on the first planarization layer PL1, the second planarization layer PL2 and the anode electrode ANO. A cathode electrode CAT may be deposited on the emission layer EL. The cathode electrode CAT may be in surface contact with the emission layer EL. Therefore, the emission layer EL and the cathode electrode CAT may be stacked along the cross-sectional profile of the first planarization layer PL1 and the second planarization layer PL2. Accordingly, at the part where there is a difference in thickness, i.e., the step part, between the first planarization layer PL1 and the second planarization layer PL2, a micro-mirror MR structure may be formed as described in FIG. 4 and FIG. 5.

Here, the sidewall inclined angle $\theta'$ of the second planarization layer PL2 formed as being extruded upward from the upper surface of the first planarization layer PL1 may be the same as the sidewall inclined angle $\theta'$ described with FIG. 5. Similarly, the inclined angle $\theta$ of the cathode electrode CAT deposited on the first planarization layer PL1 and the second planarization layer PL2 may be substantially the same as the sidewall inclined angle $\theta'$ of the second planarization layer PL2.

The second planarization layer PL2 may have a refractive index higher than that of the first planarization layer PL1. For example, the anode electrode ANO may have a refractive index from 2.0 to 2.3. The second planarization layer PL2 may have a refractive index of 1.8 to 2.0, which is the same as or about 0.2 different from the refractive index of the anode electrode ANO. Meanwhile, the first planarization layer PL1 may include a transparent organic material having a refractive index of 1.3 to 1.5, which is at least 0.5 lower than that of the second planarization layer PL2.

Lights generated from the emission layer EL may be radiated in a 180 degree range downward by the same mechanism as described above. The anode electrode ANO is made of a transparent conductive material and the second planarization layer PL2 has a similar refractive index with the anode electrode ANO. Most of lights emitted from the emission layer EL and incident into the anode electrode ANO may enter into the second planarization layer PL2.

Since the refractive index of the second planarization layer PL2 may be slightly lower than that of the anode electrode ANO, some of lights may be totally reflected at the interface between the anode electrode ANO and the second planarization layer PL2. The totally reflected lights may be re-reflected by the micro-mirror MR structure formed at the circumference of the anode electrode ANO, and then may be radiated outside.

Since the difference in refractive index between the anode electrode ANO and the second planarization layer PL2 may not be large, most of lights may be incident into the second planarization layer PL2 and may be emitted downward. The optical path along which the light is extracted is indicated by an arrow in FIG. 8.

In addition, lights emitted from the emission layer EL may be radiated downward with 180 degree diffusion angle and may enter into the second planarization layer PL2. The second planarization layer PL2 may be surrounded by the first planarization layer PL1. Therefore, some of lights passing through the second planarization layer PL2 may enter into the interface with the first planarization layer PL1. As the first planarization layer PL1 may have lower refractive index than the second planarization layer PL2, the second planarization layer PL2 having higher refractive index is surrounded by the first planarization layer PL1 having lower refractive index.

This structure is similar to that of an optical fiber, so the lights passing through the second planarization layer PL2 and going to the first planarization layer PL1 may be totally reflected at the interface with the first planarization layer PL1, and may be guided downward along the thickness direction (Z-axis direction). That is, most of lights incident into the upper surface of the second planarization layer PL2 may be emitted to the color filter CF placed at the lower part of the second planarization layer PL2, due to the total reflection process inside the second planarization layer PL2.

Among the lights emitted from the emission layer EL in the middle region of the anode electrode ANO in a plan view, a portion, such as 20% to 30%, of the lights may propagate laterally (horizontal or X-axis direction) and then disappear while repeating the total reflection process inside the anode electrode ANO. However, in the third implementation, the second planarization layer PL2 may be formed of a material having a refractive index difference of 0.2 or less from the anode electrode ANO. Therefore, most of the lights passing through the anode electrode ANO may not be totally reflected at the interface with the second planarization layer PL2, but be incident into the second planarization layer PL2 and then be emitted through the color filter CF.

Further, among the lights incident into the second planarization layer PL2, the lights diffused to viewing angle may be incident into the first planarization layer PL1 surrounding the second planarization layer PL1. As the first planarization layer PL1 may be made of a material having significantly lower refractive index than that of the second planarization layer PL2, these lights may be totally reflected at the interface between the first planarization layer PL1 and the second planarization layer PL2, and then conversed within the emission area EA. Therefore, the lights may be prevented from being excessively diffused in the direction of the wide viewing angle.

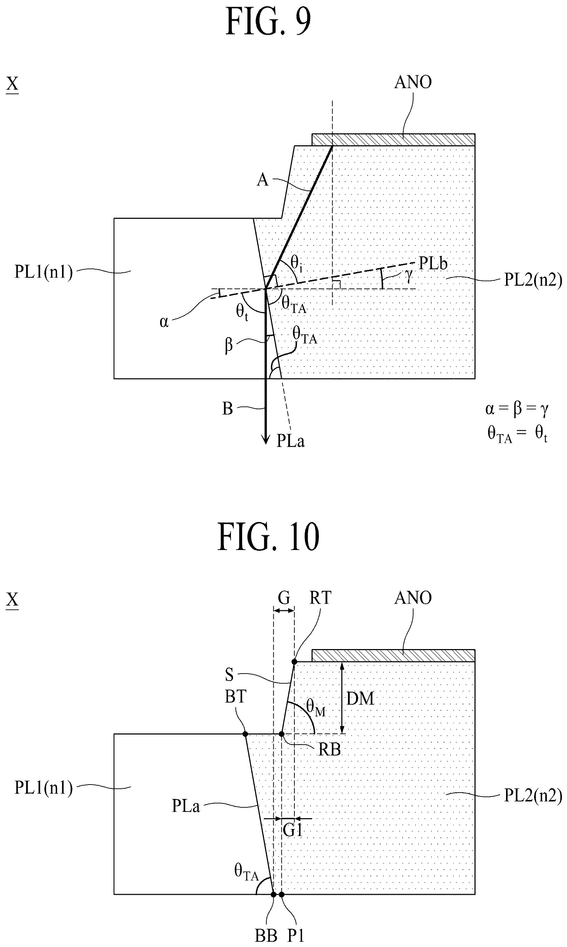

Hereinafter, referring to FIG. 9, for the light emitting display device according to the third implementation, an optical path of light propagation at the interface between the first planarization layer PL1 and the second planarization layer PL2 will be described in detail. FIG. 9 is a diagram illustrating an example of an optical path of a light at the interface between the first planarization layer and the second planarization layer of a light emitting display device according to a third implementation of the present disclosure. FIG. 9 is an enlarged drawing of the boxed area labeled "X" indicated by a dotted line in FIG. 8. In FIG. 9, only the first planarization layer PL1, the second planarization layer PL2 and the anode electrode ANO are illustrated for convenience of explanation.

The first planarization layer PL1 may have a first refractive index n1. The second planarization layer PL2 may have a second refractive index n2. The first planarization layer PL1 and the second planarization layer PL2 may have an interface PLa (or boundary surface) in the vertical direction. The interface PLa (or boundary surface) may have an inclination angle $\theta_{TA}$ with respect to the bottom surface of the first planarization layer PL1 and the second planarization layer PL2.

Among the lights passing through the anode electrode ANO, lights that travels in the direction of the viewing angle may pass through the second planarization layer PL2 and may be incident into the first planarization layer PL1. The incident light into the first planarization layer PL1 may be refracted at the interface PLa between the first planarization layer PL1 and the second planarization layer PL2. That is, the incident light A through the second planarization layer PL2 may propagate as the refracted light B into the first planarization layer PL1 after passing through the interface PLa.

Here, the condition for causing the refracted light B to be emitted in the front direction (i.e., in the direction perpendicular to the bottom surface of the first planarization layer PL1 and the second planarization layer PL2) is also shown in FIG. 9. The incident angle of the light being incident to the interface PLa within the second planarization layer PL2 (i.e., the angle of incident light between the normal plane PLb of the interface PLa and the incident light A) may be '$\theta_i$'. The refraction angle of the light being refracted at the interface PLa into the first planarization layer PL1 (i.e., the angle of refracted light between the normal plane PLb of the interface PLa and the refracted light B) may be '$\theta_t$'. In this situation, the relationship between the inclination angle $\theta_{TA}$ of the interface PLa and the refraction angle $\theta_t$ may be determined by Snell's Law as follows.

$$n1 \cdot \sin\theta_i = n2 \cdot \sin\theta_t \quad (\text{Snell's Law})$$

$$\cot\theta_{TA} = \frac{(\cos(\theta_{TA}-\theta_i)-(n2/n1))}{\sin(\theta_{TA}-\theta_i)}$$

Considering the above formula, when calculating the condition for allowing the refracted light B to be emitted within a range of 10 degrees from the direction perpendicular to the bottom surface of the first planarization layer PL1 and the second planarization layer PL2, the inclination angle $\theta_{TA}$ of the interface PLa may have any one angle in a range of 30 degree to 90 degree.

Hereinafter, referring to FIG. 10, the positional relationship between the first planarization layer PL1 and the second planarization layer PL2 according to the third implementation of the present disclosure will be explained. FIG. 10 is a diagram for illustrating an example of a relationship between the first planarization layer PL1 and the second planarization layer PL2 of a light emitting display device according to a third implementation of the present disclosure.

The first planarization layer PL1 and the second planarization layer PL2 may be in surface contact with each other by the interface PLa. The interface PLa between the first planarization layer PL1 and the second planarization layer PL2 may have a line segment shape connecting an interface top point BT and an interface bottom point BB in the cross-sectional view.

The second planarization layer PL2 may have a protrusion height DM extruded upward from the upper surface of the first planarization layer PL1, in order to establish the micro-mirror structure. Further, the second planarization layer PL2 may have a protrusion angle $\theta_M$ inclined from the upper surface of the first planarization layer PL1. That is, the second planarization layer PL2 may have a sidewall S extended from a protrusion bottom point RB to a protrusion top point RT. The inclined angle of the sidewall S may be the protrusion angle $\theta_M$. For example, the protrusion angle $\theta_M$ may be any one angle in range of 50 degrees to 80 degrees.

The interface PLa and the sidewall S may have incline directions opposite to each other. For example, the interface bottom point BB of the interface PLa may be on the same vertical line as the protrusion bottom point RB or be spaced a certain distance outward the protrusion bottom point RB. In some implementations, the interface bottom point BB of the interface PLa may be positioned at a certain distance outward the protrusion bottom point RB of the sidewall S (i.e., at a position tilted toward the first planarization layer PL1). The interface bottom point BB may be the same as a first point P1 where the vertical line from the protrusion bottom point RB to the bottom surface of the second planarization layer PL2 may meet the second planarization layer PL2, or be positioned at a certain distance from the first point P1 toward the first planarization layer PL1.

Here, the lateral distance G1 between the protrusion top point RT and the protrusion bottom point RB of the sidewall S may be acquired from the following equation.

$$\text{Lateral Distance (G1)} = \text{Protrusion Height (DM)} / \tan\Theta_M$$

Therefore, a horizontal gap G between the interface bottom point BB of the interface PLa and the protrusion top point RT of the sidewall S may be equal to or greater than the lateral distance G1, as shown in the following equation.

$$\text{Horizontal Gap (G)} \geqq \text{Protrusion Height (DM)} / \tan\Theta_M$$

The light emitting display device according to the third implementation may have enhanced efficiency for extracting the lights from the emission area EL due to the cathode electrode CAT having the micro-mirror MR structure which is formed with the second planarization layer PL2 having the extruded shape and being disposed under the anode electrode ANO. In particular, since the second planarization layer PL2 may have a refractive index the same as the anode electrode ANO or slightly lower than the anode electrode ANO, the light extraction efficiency may be further enhanced by extracting lights which may otherwise be lost by the total reflection phenomenon. Furthermore, the first planarization layer PL1 surrounding the second planarization layer PL2 may have lower refractive index than that of the second planarization layer PL2, so that the lights emitted from the emission area where the anode electrode ANO is disposed may be concentrated within the area where the second planarization layer PL2 is disposed. Accordingly, the luminance at frontal direction may be enhanced.

As the interface PLa may have an inclined angle, the interface PLa may not clearly define the boundary between the emission area EA and the non-emission area NEA. However, there may be an effect of focusing the lights provided from the light emitting diode OLE by total reflection at the interface PLa onto the area where the second planarization layer PL2 is arranged. Accordingly, the location of the interface PLa between the first planarization layer PL1 and the second planarization layer PL2 may be set on the boundary between the emission area EA and the non-emission area NEA. For the light emitting display device according to the third implementation, the first planarization layer PL1 may be disposed as corresponding to the non-emission area NEA, and the second planarization layer PL2 may be disposed as corresponding to the emission area EA.

<Fourth Implementation>

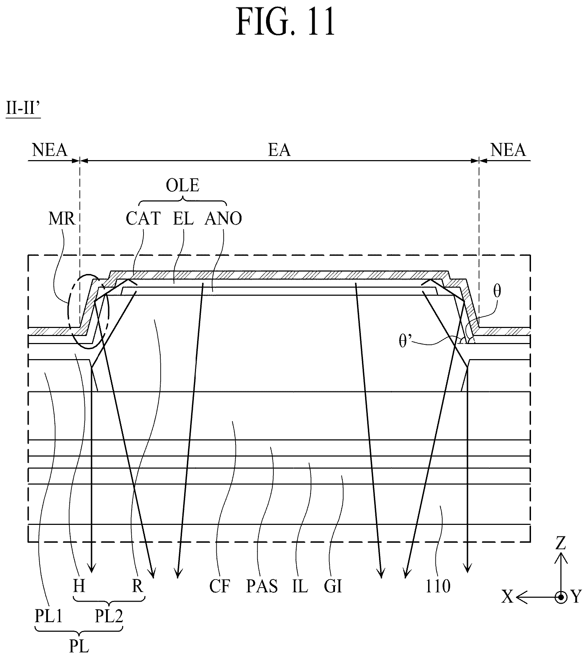

Hereinafter, referring to FIG. 11, an example of a structure of a light emitting display device according to a fourth implementation of the present disclosure will be explained. FIG. 11 is an enlarged cross-sectional view, taken along line II-II' of FIG. 3, illustrating a structure of a light emitting display device according to a fourth implementation of the present disclosure.

The light emitting display device according to a fourth implementation may be similar to the light emitting display device according to the third implementation. However, one of the main differences in the fourth implementation is that the second planarization layer PL2 may cover the first planarization layer PL1.

Referring to FIG. 11, a pixel P may include an emission area EA and a non-emission area NEA. In FIG. 11, the emission area EA may include the micro-mirror MR and the light emitting diode OLE. The non-emission area NEA may be the area except the emission area EA.

A gate insulating layer GI, an intermediate insulating layer IL and a passivation layer PAS may be sequentially stacked on the substrate 110. A color filter CF may be deposited on the passivation layer PAS. A planarization layer PL may be deposited on the color filter CF.

The planarization layer PL may include a first planarization layer PL1 and a second planarization layer PL2. The first planarization layer PL1 may be disposed at the non-emission area NEA corresponding to the circumferential areas of the anode electrode ANO within the pixel P. The second planarization layer PL2 may be deposited on entire surface of the substrate 110 as covering the first planarization layer PL1. In particular, the second planarization layer PL2 may include a flat portion H and a protrusion portion R.

The flat portion H of the second planarization layer PL2 may cover the first planarization layer PL1. The protrusion potion R may be disposed at the emission area EA where the anode electrode ANO is formed. In particular, the protrusion portion R may have an extruded shape upward from the flat portion H, and may have a thickness thicker than the summation of the first planarization layer PL1 and the flat portion H sequentially stacked. The upper surface of the protrusion portion R may be located at higher position from the upper surface of the flat portion H.

An anode electrode ANO may be formed on the second planarization layer PL2 and disposed on the upper surface of the protrusion portion R. An emission layer EL may be deposited on the second planarization layer PL2 and the anode electrode ANO. A cathode electrode CAT may be deposited on the emission layer EL. The cathode electrode CAT may be in surface contact with the emission layer EL. Therefore, the emission layer EL and the cathode electrode CAT may be deposited along the cross-sectional profile shape of the second planarization layer PL2. Accordingly, a micro-mirror MR structure may be formed at the difference in thickness between the flat portion H and the protruding portion R, i.e., the step portion.

Here, the sidewall inclined angle θ' of the protrusion portion R which is extruded upward from the flat portion H of the second planarization layer PL2 may be the same as the sidewall inclined angle θ' described with FIG. 5. Similarly, the inclined angle θ of the cathode electrode CAT deposited on the second planarization layer PL2 may be substantially the same as the sidewall inclined angle θ' of the protrusion portion R.

The second planarization layer PL2 may have a refractive index higher than that of the first planarization layer PL1. For example, the anode electrode ANO may have a refractive index of 2.0 to 2.3. The second planarization layer PL2 may have a refractive index of 1.8 to 2.0, which is the same as or about 0.2 different from the refractive index of the anode electrode ANO. Meanwhile, the first planarization layer PL1 may have a refractive index of 1.3 to 1.5, which is at least 0.5 lower than that of the second planarization layer PL2.

Lights generated from the emission layer EL may be radiated in a 180 degree range downward by the same mechanism as described above. The anode electrode ANO is made of a transparent conductive material and the second planarization layer PL2 has a similar refractive index with the anode electrode ANO. Most of lights emitted from the emission layer EL and incident into the anode electrode ANO may enter into the second planarization layer PL2.

Since the difference in refractive index between the anode electrode ANO and the second planarization layer PL2 may not be large, most of lights may be incident into the second planarization layer PL2 and may be emitted downward. The optical path along which the light is extracted is indicated by an arrow in FIG. 11.

In addition, lights emitted from the emission layer EL may be radiated downward with 180 degree diffusion angle and may enter into the second planarization layer PL2. The second planarization layer PL2 may be surrounded by the first planarization layer PL1. As the first planarization layer PL1 may have lower refractive index than the second planarization layer PL2, the second planarization layer PL2 having higher refractive index is surrounded by the first planarization layer PL1 having lower refractive index.

This structure is similar to that of an optical fiber. Therefore, among the lights incident into the second planarization PL2, the lights incident on the interface with the first planarization layer PL1 may be refracted to the substrate 110 or may be totally reflected. As a result, most of lights incident into the second planarization layer PL2 having high refractive index may be condensed within the second planarization layer PL2 by the first planarization layer PL1 having lower refractive index and surrounding the second planarization layer PL2, and then may be guided downward direction. That is, most of lights incident into the upper surface of the second planarization layer PL2 may be emitted to the color filter CF placed at the lower part of the second planarization layer PL2, due to the total reflection process inside the second planarization layer PL2.

Meanwhile, among the lights emitted from the emission layer EL in the middle region of the anode electrode ANO in a plan view, a portion, such as 20% to 30%, of the lights may propagate laterally (horizontal or X-axis direction) and then disappear while repeating the total reflection process inside the anode electrode ANO. In the fourth implementation, the second planarization layer PL2 may be formed of a material having a refractive index difference of 0.2 or less compared to the anode electrode ANO. Therefore, most of the lights passing through the anode electrode ANO may not be totally reflected at the interface with the second planarization layer PL2, but may be incident into the second planarization layer PL2 and then be emitted through the color filter CF.

Further, among the lights incident into the second planarization layer PL2, the lights diffused to viewing angle may be incident into the first planarization layer PL1 surrounding the second planarization layer PL1. As the first planarization layer PL1 may be made of a material having significantly lower refractive index than that of the second planarization layer PL2, these lights may be totally reflected at the interface between the first planarization layer PL1 and the second planarization layer PL2, and then conversed within the emission area EA. Therefore, the lights may be prevented from being excessively diffused in the direction of the wide viewing angle.

The light emitting display device according to the fourth implementation may have enhanced efficiency for extracting the lights from the emission area EL due to the cathode electrode CAT having the micro-mirror MR structure which is formed with the second planarization layer PL2 having the extruded shape and being disposed under the anode electrode ANO. In particular, since the second planarization layer PL2 may have a refractive index the same as the anode electrode ANO or slightly lower than the anode electrode ANO, the light extraction efficiency may be further enhanced by extracting lights which may otherwise be lost by the total reflection phenomenon. Furthermore, the first planarization layer PL1 surrounding the second planarization layer PL2 may have lower refractive index than that of the second planarization layer PL2, so that the lights emitted from the emission area where the anode electrode ANO is disposed may be concentrated within the area where the second planarization layer PL2 is disposed. Accordingly, the luminance at frontal direction may be enhanced.

As the sidewall of the first planarization layer PL1 may have an inclined angle, the first planarization layer PL1 may not be disposed only in the non-emission area NEA, but may be disposed in a part of the emission area EA. However, there may be an effect of focusing the lights provided from the light emitting diode OLE by total reflection at the sidewall of the first planarization layer PL1 onto the area where the second planarization layer PL2 is arranged. Therefore, in some implementations, the sidewall of the second planarization layer PL2 may be located as the boundary between the emission area EA and the non-emission area NEA. For the light emitting display device according to the fourth implementation, the first planarization layer PL1 may be disposed as corresponding to the non-emission area NEA, and the second planarization layer PL2 may be disposed as corresponding to the emission area EA and the non-emission area NEA. In this scenario, the flat portion H of the second planarization layer PL may be disposed as corresponding to the non-emission area NEA, and the protrusion portion R may be disposed as corresponding to the emission area EA.

<Fifth Implementation>

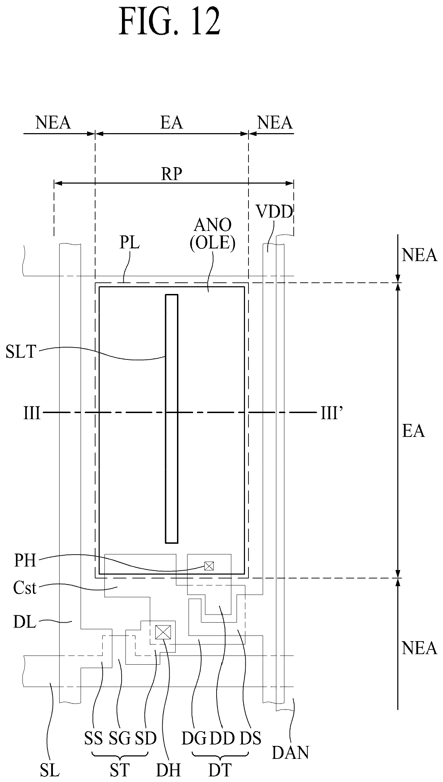

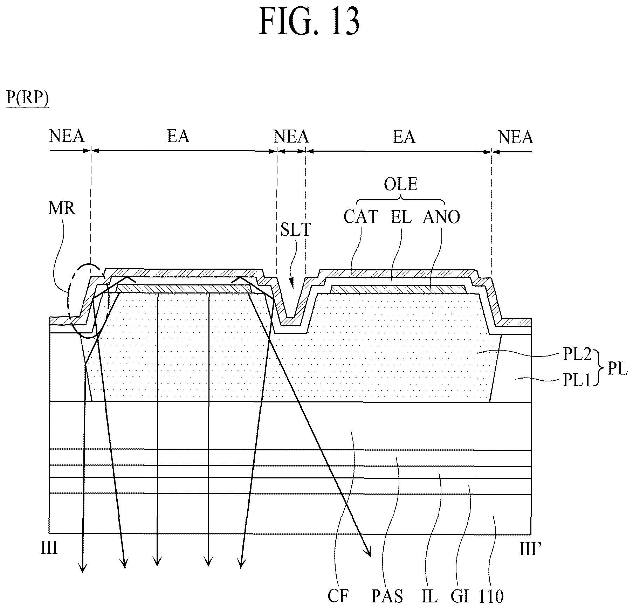

Hereinafter, referring to FIG. 12 and FIG. 13, examples of a structure of a fifth implementation of the present disclosure will be explained. FIG. 12 is an enlarged plan view illustrating a structure of a light emitting display device according to a fifth implementation of the present disclosure. FIG. 13 is an enlarged cross-sectional view, taken along line III-III' of FIG. 12, illustrating a structure of a light emitting display device according to a fifth implementation of the present disclosure.

Referring to FIG. 12, the light emitting display device according to the fifth implementation of the present disclosure may include a slit SLT disposed at the middle portion of the anode electrode ANO in the red pixel RP, the slit SLT having a rectangular shape in which vertical length (along Y axis) is longer than the horizontal length (along X axis). In FIG. 12, one slit SLT is disposed at the middle portion of the anode electrode ANO, and so the anode electrode ANO may appear divided into two portions including a left region and a right region. However, implementations are not limited thereto, and the slit SLT may be disposed as various types. In the example of FIG. 12, the slit SLT is disposed within the red pixel RP, but other pixels, e.g., green pixel GP, blue pixel BP and white pixel WP, may have slits SLT implemented in a similar manner.

As another example, a plurality of slits, e.g., 2 or 5 slits, may be arranged side by side at regular intervals in the horizontal direction (X-axis direction) within the area of the anode electrode ANO. As another example, the slit SLT may be arranged at the middle portion of the anode electrode ANO in rectangular shape with a longer length in the horizontal direction (X-axis direction). Additionally, a plurality of slits SLT may be arranged at regular intervals along the vertical direction (Y-axis direction). However, implementations are not limited thereto, and the slit SLT may be arranged in other shapes, such as an 'X' shape or '+' shape.

Referring to the example of FIG. 13, the light emitting display device according to the fifth implementation may include a gate insulating layer GI, an intermediate insulating layer IL and a passivation layer PAS which are sequentially stacked on the substrate 110. A color filter CF may be deposited on the passivation layer PAS. A planarization layer PL may be deposited on the color filter CF.

The planarization layer PL may include a first planarization layer PL1 and a second planarization layer PL2. The first planarization layer PL1 may be disposed at the non-emission area NEA in the pixel P, and the second planarization layer PL2 may be disposed at the emission area EA in the pixel P. The second planarization layer PL2 may have an extruded shape upward from the upper surface of the first planarization layer PL1. The upper surface of the second planarization layer PL2 may be located at higher position than the upper surface of the first planarization layer PL1. In other words, the second planarization layer PL2 may have a thickness thicker than that of the first planarization layer PL1.

The slit SLT may be formed at the middle portion of the second planarization layer PL2 disposed as corresponding to the emission area EA of the pixel P. The height of the slit T formed by patterning the second planarization layer PL2 may be the same with that of the first planarization layer PL1. However, implementations are not limited thereto, and the height of the slit SLT may vary.

An anode electrode ANO may be disposed on the upper surface of the second planarization layer PL2. In this example, within the slit SLT, the anode electrode ANO may not be disposed. In this case, as the anode electrode ANO is not formed in the slit SLT, there is no light emitting diode OLE in the slit SLT. Therefore, the slit SLT may be included in the non-emission area NEA. In some implementations, the cathode electrode CAT may be deposited on the sidewall of the slit SLT to form a micro-mirror MR.

However, implementations are not limited thereto, and the anode electrode ANO may be disposed within the slit SLT. In this case, the anode electrode ANO may be deposited as a single layer without any broken portion at the middle portion of the upper surface of the second planarization layer PL2. Therefore, the slit SLT may be included into the emission area EA.

As shown in FIG. 12 illustrating a plan view, the slit SLT may be disposed within the area of the anode electrode ANO, as being spaced apart at a certain distance from the upper and lower sides of the anode electrode ANO. Therefore, the anode electrode ANO may not be divided into two regions by the slit SLT, but may have a continuously connected structure within the pixel P, electrically and physically.

An emission layer EL may be deposited on the first planarization layer PL1, the second planarization layer PL2 and the anode electrode ANO. A cathode electrode CAT may be deposited on the emission layer EL. The cathode electrode CAT may be in surface contact with the emission layer EL. Therefore, the emission layer EL and the cathode electrode CAT may be stacked along the cross-sectional profile of the first planarization layer PL1 and the second planarization layer PL2. Accordingly, at the part where there is a difference in thickness, i.e., the step part, between the first planarization layer PL1 and the second planarization layer PL2, a micro-mirror MR structure may be formed as described in FIG. 4 and FIG. 5.

The second planarization layer PL2 may have a refractive index higher than that of the first planarization layer PL1. For example, the anode electrode ANO may have a refractive index of 2.0 to 2.3. The second planarization layer PL2 may have a refractive index of 1.8 to 2.0, which is the same as or about 0.2 different from the refractive index of the anode electrode ANO. Meanwhile, the first planarization layer PL1 may include a transparent organic material having a refractive index of 1.3 to 1.5, which is at least 0.5 lower than that of the second planarization layer PL2.

Lights generated from the emission layer EL may be radiated in a 180 degree range downward by the same mechanism as described above. The anode electrode ANO is made of a transparent conductive material and the second planarization layer PL2 has a similar refractive index as the anode electrode ANO. Most of lights emitted from the emission layer EL and incident into the anode electrode ANO may enter into the second planarization layer PL2.

Since the refractive index of the second planarization layer PL2 may be slightly lower than that of the anode electrode ANO, some of lights may be totally reflected at the interface between the anode electrode ANO and the second planarization layer PL2. The totally reflected lights may be re-reflected by the micro-mirror MR structure formed at the circumference of the anode electrode ANO and the slit SLT, and then may be radiated outside.

Since the difference in refractive index between the anode electrode ANO and the second planarization layer PL2 may not be large, most of lights may be incident into the second planarization layer PL2 and may be emitted downward. The optical path along which the light is extracted is indicated by an arrow in FIG. 13.

In addition, lights emitted from the emission layer EL may be radiated downward with 180 degree diffusion angle and may enter into the second planarization layer PL2. The second planarization layer PL2 may be surrounded by the first planarization layer PL1. Therefore, some of lights passing through the second planarization layer PL2 may enter into the interface with the first planarization layer PL1. As the first planarization layer PL1 may have lower refractive index than the second planarization layer PL2, the second planarization layer PL2 having higher refractive index is surrounded by the first planarization layer PL1 having lower refractive index.

This structure is similar to that of an optical fiber, so the lights passing through the second planarization layer PL2 and going to the first planarization layer PL1 may be totally reflected at the interface with the first planarization layer PL1, and may be guided downward along the thickness direction (Z-axis direction). That is, most of lights incident into the upper surface of the second planarization layer PL2 may be emitted to the color filter CF placed at the lower part of the second planarization layer PL2, due to the total reflection process inside the second planarization layer PL2.

Among the lights emitted from the emission layer EL in the middle region of the anode electrode ANO in a plan view, a portion, such as 20% to 30%, of the lights may propagate laterally (horizontal or X-axis direction) and then disappear while repeating the total reflection process inside the anode electrode ANO. In the fifth implementation, the second planarization layer PL2 may be formed of a material having a refractive index difference of 0.2 or less from the anode electrode ANO. Therefore, most of the lights passing through the anode electrode ANO may be incident into the second planarization layer PL2 and then be emitted through the color filter CF.

Among the lights emitted from the emission layer EL in the middle region of the anode electrode ANO in a plan view, a portion, such as 20% or less, of the lights may propagate laterally (horizontal or X-axis direction) by total reflection. However, most of these lights may be reflected by the micro-mirror MR structure formed at circumferences of the anode electrode ANO and at the slit SLT to be radiated into the second planarization layer PL2.

Further, among the lights incident into the second planarization layer PL2, the lights diffused to viewing angle may be incident into the first planarization layer PL1 surrounding the second planarization layer PL1. As the first planarization layer PL1 may be made of a material having significantly lower refractive index than that of the second planarization layer PL2, these lights may be totally reflected at the interface between the first planarization layer PL1 and the second planarization layer PL2, and then conversed within the emission area EA. Therefore, the lights may be prevented from being excessively diffused in the direction of the wide viewing angle.

In the light emitting display device according to the fifth implementation, the optical path of the light at the interface between the first planarization layer PL1 and the second planarization layer PL2 may be same as described in the fourth implementation. Further, the location relationship between the first planarization layer PL1 and the second planarization layer PL2 for the fifth implementation may be the same as the fourth implementation.

The fifth implementation of the present disclosure may provide a bottom emission type light emitting display device having enhanced light extraction efficiency due to the micro-mirror structure. Further, the light emitting display device according to the fifth implementation may have different refractive index in stacked planarization layers, and may be configured to improve light conversing efficiency to enhance luminance at the frontal direction. The light emitting display device according to the fifth implementation of the present disclosure may provide higher luminance with the same power consumption. In other words, the light emitting display device according to the fifth implementation may lower the power consumption required to provide the same luminance, thus enabling low-power operation.

<Sixth Implementation>

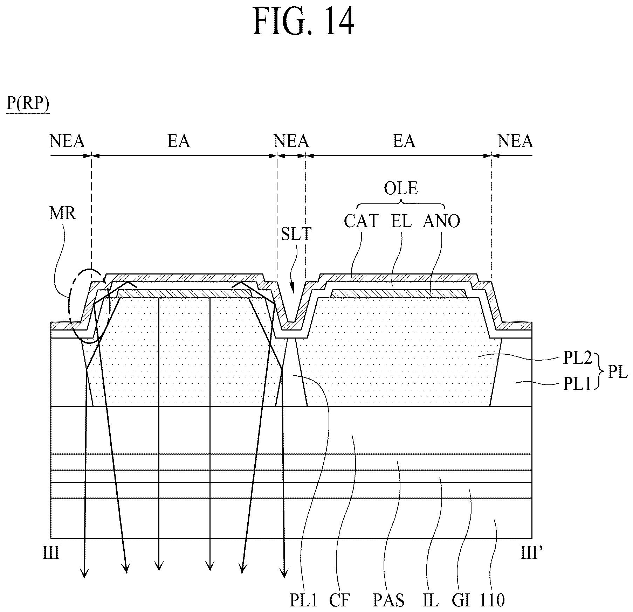

Hereinafter, referring to FIG. 14, an example of a light emitting display device according to a sixth implementation of the present disclosure will be explained. FIG. 14 is an enlarged cross-sectional view, taken along line III-III' of FIG. 12, illustrating a structure of a light emitting display device according to a sixth implementation of the present disclosure.

Referring to FIG. 14, a light emitting display device according to the sixth implementation may have a similar structure as the fifth implementation described with reference to FIG. 13. One of the different features is that, in the sixth implementation, the second planarization layer PL2 may be removed from where the slit SLT is formed, and the first planarization layer PL1 may be filled thereinto.

As the anode electrode ANO may be not deposited where the slit SLT is formed, the slit SLT may be included into the non-emission area NEA. However, implementations are not limited thereto, the anode electrode ANO may be extended to the slit SLT. In this case, the slit SLT may be included into the emission area EA. Further, as the cathode electrode CAT may be deposited on the sidewall of the slit SLT, the micro-mirror MR may be formed at the sidewall of the slit SLT.

In the fifth implementation described above, lights from the left region and the right region of the anode electrode ANO divided by the slit SLT may pass through the under region of the slit SLT, as shown in FIG. 13. However, the amount of the lights passing through the under region of the slit SLT may be small, therefore, the luminance at the slit SLT may be lower than that at the area where the anode electrode ANO is disposed.

The first planarization layer PL1 filling the space where the second planarization layer PL2 is removed from the under region of the slit SLT may have a size corresponding to the shape of the slit SLT. Further, in the cross-sectional view, the first planarization layer PL1 disposed below the slit SLT may have a regular tapered shape with a narrow upper side and a wide lower side, as shown in FIG. 14. However, implementations are not limited thereto, and the first planarization layer PL1 disposed below the slit SLT may have, in the cross-sectional view, a rectangular shape with the same size of the upper and lower sides. As another example, the first planarization layer PL1 disposed below the slit SLT may have a reverse tapered shape with a wide upper side and a narrow lower side.

In order to increase the light conversing efficiency in the frontal direction of the light emitted from the regions where the anode electrode ANO is placed, as shown in FIG. 14, the first planarization layer PL1 may have a regular tapered trapezoid shape in cross-sectional view, and the second planarization layer PL2 may have a reverse tapered trapezoid shape. However, in scenarios where the viewing angle luminance of the light emitted from the region where the anode electrode ANO is placed is to be improved to some extent, the first planarization layer PL1 may be formed to have a reverse tapered trapezoid shape, and the second planarization layer PL2 may have a regular tapered trapezoid shape.

Accordingly, in the sixth implementation, by placing the first planarization layer PL1 at the below area where the slit SLT is placed, the frontal conversing efficiency of the light provided from the area where the anode electrode ANO is placed may be improved. Therefore, the sixth implementation may provide a light emitting display device having enhanced frontal luminance.

The fifth implementation of the present disclosure may provide a bottom emission type light emitting display device having enhanced light extraction efficiency due to the micro-mirror structure. Further, the light emitting display device according to the fifth implementation may have different refractive index in stacked planarization layers, and may be configured to improve light conversing efficiency to enhance luminance at the frontal direction. In particular, the light emitting display device according to the sixth implementation may further improve the frontal luminance by focusing lights emitted from the area where the anode electrode ANO is placed in the frontal direction below the anode electrode ANO.

<Seventh Implementation>

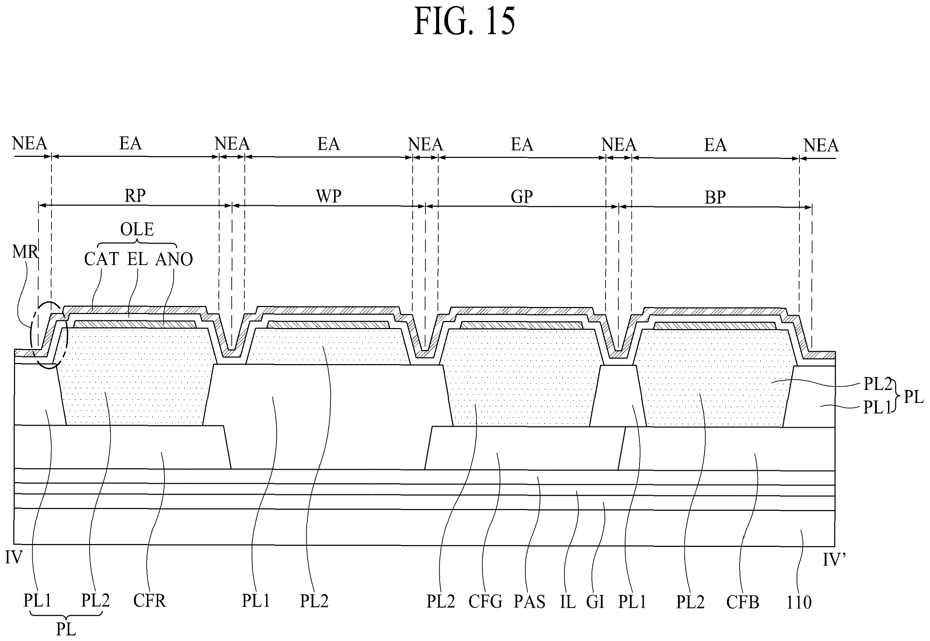

Hereinafter, referring to FIG. 15, an example of a seventh implementation will be explained. FIG. 15 is an enlarged cross-sectional view, taken along line IV-IV' of FIG. 3, illustrating a structure of a light emitting display device according to a seventh implementation of the present disclosure.

From the first implementation to the sixth implementation, various structures of the planarization layer PL placed under the anode electrode ANO in one pixel have been explained. In the seventh implementation, a structure is described that considers the optical characteristics of each pixel in which red pixel RP, white pixel WP, green pixel GP and blue pixel BP configuring a unit pixel may be arranged in serial.

Referring to FIG. 15, a pixel P may include an emission area EA and a non-emission area NEA. In FIG. 15, the emission area EA may include the micro-mirror MR and the light emitting diode OLE. The area outside the emission area EA may be the non-emission area NEA.

The light emitting display device according to the seventh implementation may include a gate insulating layer GI, an intermediate insulating layer IL and a passivation layer PAS which are sequentially stacked on the substrate 110. A color filter CF may be deposited on the passivation layer PAS. The color filter CF may include a red color filter CFR, a green color filter CFG and a blue color filter CFB. The red color filter CFR may be disposed at the red pixel RP. The green color filter CFG may be disposed at the green pixel GP. The blue color filter CFB may be disposed at the blue pixel BP. The white pixel WP may have not color filter. However, it is not limited thereto, the white pixel WP may include a transparent organic material with the same thickness as the other color filters.

The planarization layer PL may include a first planarization layer PL1 and a second planarization layer PL2. As shown in FIG. 15, the configuration of the planarization layer PL may be different from each pixel. For example, the white pixel WP may include the first planarization layer PL1 at the emission area EA and the non-emission area NEA. However, for other pixels, the first planarization layer PL1 may be disposed at the non-emission area NEA except the emission area EA. The emission area EA may be the area where the light emitting diode OLE may be disposed, but the non-emission area NEA may be the area surrounding the light emitting diode OLE. In some cases, the area where the micro-mirror MR is formed may be included into the emission area EA. The first planarization layer PL1 may have a first thickness. The second planarization layer PL2 may be formed at the emission area EA. The second planarization layer PL2 may have a second thickness thicker than the first thickness.

For example, in the white pixel WP, the second planarization layer PL2 may be formed so as to have a shape extruded upward only in a portion corresponding to the emission area EA above the first planarization layer PL1. In the red pixel RP, the green pixel GP and the blue pixel BP, the emission area EA may include only the second planarization layer PL2. For this case, the first planarization layer PL1 may be arranged to surround the second planarization layer PL2.

An anode electrode ANO may be disposed on the upper surface of the second planarization layer PL2 corresponding to the emission area EA of the pixel P. An emission layer EL may be deposited on the first planarization layer PL1, the second planarization layer PL2 and the anode electrode ANO. A cathode electrode CAT may be deposited on the emission layer EL. The cathode electrode CAT may be in surface contact with the emission layer EL. Therefore, the emission layer EL and the cathode electrode CAT may be stacked along the cross-sectional profile of the first planarization layer PL1 and the second planarization layer PL2. Accordingly, at the part where there is a difference in thickness, i.e., the step part, between the first planarization layer PL1 and the second planarization layer PL2, a micro-mirror MR structure may be formed.

The second planarization layer PL2 may have a refractive index higher than that of the first planarization layer PL1. For example, the anode electrode ANO may have a refractive index of 2.0 to 2.3. The second planarization layer PL2 may have a refractive index of 1.8 to 2.0, which is the same as or about 0.2 different from the refractive index of the anode electrode ANO. Meanwhile, the first planarization layer PL1 may include a transparent organic material having a refractive index of 1.3 to 1.5, which is at least 0.5 lower than that of the second planarization layer PL2.

The white pixel WP may have the same structure described in the first implementation, as shown in FIG. 6. Therefore, the lights emitted from the light emitting diode OLE of the white pixel WP may propagate according to the same mechanism as explained in the first implementation.

The red pixel RP, the green pixel GP and the blue pixel BP may have a structure which is the same as the structure described in the third implementation as shown in FIG. 8. Therefore, the lights generated from each light emitting diode OLE of the red pixel RP, the green pixel GP and the blue pixel BP may propagate according to the same mechanism as explained in the third implementation.

As a result, the red pixel RP, the green pixel GP and the blue pixel BP may have the high light condensing effect in the frontal direction, and therefore a high frontal luminance may be achieved. Meanwhile, the white pixel WP may achieved a viewing angle luminance higher than that of the other pixels.

In the seventh implementation, a scenario is described in which no slit is provided within each pixel. However, implementations are not limited thereto, and one slit or a plurality of slits may be disposed at each pixel, similar to the fifth implementation or the sixth implementation.

The seventh implementation of the present disclosure may provide a bottom emission type light emitting display device having enhanced light extraction efficiency due to the micro-mirror structure. Further, the planarization layer may have different configuration per each pixel, it may be configured to enhance the frontal luminance or the viewing angle luminance depending on each of the pixels. As a result, the color luminance configuration may be acquired in one unit pixel including a red pixel RP, a white pixel WP, a green pixel GP and a blue pixel BP. The light emitting display device according to the seventh implementation of the present disclosure may provide higher luminance with the same power consumption. Further, the light emitting display device according to the seventh implementation may lower the power consumption required to provide the same luminance, thus enabling the low-power operation.

<Eighth Implementation>

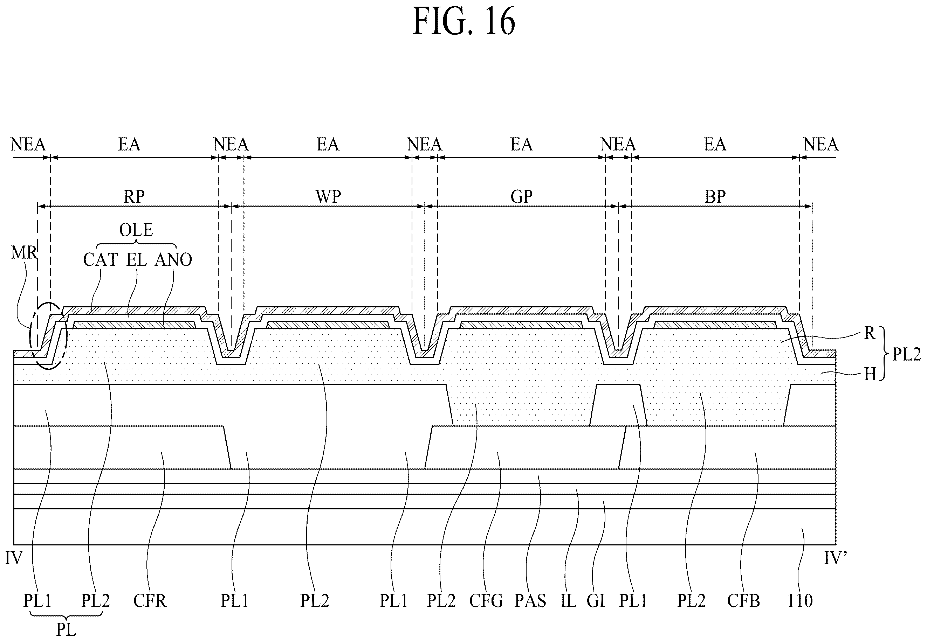

Hereinafter referring to FIG. 16, an example of an eighth implementation will be explained. FIG. 16 is an enlarged cross-sectional view, taken along line IV-IV' of FIG. 3, illustrating a structure of a light emitting display device according to a eighth implementation of the present disclosure.

The light emitting display device according to the eighth implementation may have a structure similar to the structure of the seventh implementation. One of the main differences of the eighth implementation is that red pixel RP and the white pixel WP may have the same stack structure for the planarization PL, and the green pixel GP and the blue pixel BP may have the same stack structure for the planarization layer PL. Further, the second planarization layer PL2 may completely cover the first planarization layer PL1.

Referring to FIG. 16, a pixel P may include an emission area EA and a non-emission area NEA. In FIG. 16, the emission area EA may include the micro-mirror MR and the light emitting diode OLE. The area outside the emission area EA may be the non-emission area NEA.

The light emitting display device according to the eighth implementation may include a gate insulating layer GI, an intermediate insulating layer IL and a passivation layer PAS which are sequentially stacked on the substrate 110. A color filter CF may be deposited on the passivation layer PAS. The color filter CF may include a red color filter CFR, a green color filter CFG and a blue color filter CFB. The red color filter CFR may be disposed at the red pixel RP. The green color filter CFG may be disposed at the green pixel GP. The blue color filter CFB may be disposed at the blue pixel BP. The white pixel WP may have not color filter. However, it is not limited thereto, and the white pixel WP may include a transparent organic material with the same thickness as the other color filters.

The planarization layer PL may include a first planarization layer PL1 and a second planarization layer PL2. As shown in FIG. 16, the configuration of the planarization layer PL may be different from each pixel. For example, the first planarization layer PL1 may be deposited at the emission area EA and the non-emission area NEA, and the second planarization layer PL2 may be deposited as covering the first planarization layer PL1. In particular, the second planarization layer PL2 may include a flat portion H and a protrusion portion R. The flat portion H may be disposed at the non-emission area NEA, and the protrusion portion R may be disposed at the emission area EA. The emission area EA may be the area where the light emitting diode OLE is formed. The non-emission area NEA may be the area surrounding the emission area EA. In some cases, the area where the micro-mirror MR is formed may be included into the emission area EA.

The first planarization layer PL1 may have a first thickness. The flat portion H of the second planarization layer PL2 may be stacked on the first planarization layer PL1 with a thickness that is thinner than the first thickness. The protrusion portion R may be extruded upward from the upper surface of the flat portion H with a second thickness that is thicker than the first thickness.

In the green pixel GP and the blue pixel BP, the first planarization layer PL1 is disposed at the non-emission area NEA except the emission area EA. The second planarization layer PL2 may be disposed on the non-emission area NEA and the emission area EA while covering the first planarization layer PL1.

An anode electrode ANO may be deposited on the upper surface of the protrusion portion R of the second planarization layer PL2 corresponding to the emission area EA of the pixel P. An emission layer EL may be deposited on the second planarization layer PL2 and the anode electrode ANO. A cathode electrode CAT may be deposited on the emission layer EL. The cathode electrode CAT may be in surface contact with the emission layer EL. Therefore, the emission layer EL and the cathode electrode CAT may be stacked along the cross-sectional profile of the first planarization layer PL1 and the second planarization layer PL2. Accordingly, at the part where there is a difference in thickness, i.e., the step part, between the first planarization layer PL1 and the second planarization layer PL2, a micro-mirror MR structure may be formed.

The second planarization layer PL2 may have a refractive index higher than that of the first planarization layer PL1. For example, the anode electrode ANO may have a refractive index of 2.0 to 2.3. The second planarization layer PL2 may have a refractive index of 1.8 to 2.0, which is the same as or about 0.2 different from the refractive index of the anode electrode ANO. Meanwhile, the first planarization layer PL1 may include a transparent organic material having a refractive index of 1.3 to 1.5, which is at least 0.5 lower than that of the second planarization layer PL2.

The red pixel RP and the white pixel WP may have the same structure as the second implementation shown in FIG. 7. Therefore, the lights emitted from the light emitting diode OLE of the red pixel RP and the white pixel WP may propagate according to the same mechanism as explained in the second implementation.

Meanwhile, the green pixel GP and the blue pixel BP may have the same structure as the fourth implementation, shown in FIG. 11. Therefore, the lights emitted from the light emitting diode OLE of the green pixel GP and the blue pixel BP may propagate according to the same mechanism as explained in the fourth implementation.

As a result, as the green pixel GP and the blue pixel BP may have the high light condensing effect in the frontal direction, the high frontal luminance may be achieved. Meanwhile, the red pixel RP and the white pixel WP may achieved the viewing angle luminance that is higher than that of the other pixels.

In the eighth implementation, a scenario is described in which no slit is provided within each pixel. However, implementations are not limited thereto, and one slit or a plurality of slits may be disposed at each pixel, similar to the fifth implementation or the sixth implementation.

The eighth implementation of the present disclosure may provide a bottom emission type light emitting display device having enhanced light extraction efficiency due to the micro-mirror structure. Further, the planarization layer may have different configuration per each pixel, and may be configured to enhance the frontal luminance or the viewing angle luminance depending on each of the pixels. As a result, the color luminance configuration may be acquired in one unit pixel including a red pixel RP, a white pixel WP, a green pixel GP and a blue pixel BP. The light emitting display device according to the eighth implementation of the present disclosure may provide higher luminance with the same power consumption. Further, the light emitting display device according to the eighth implementation may lower the power consumption required to provide the same luminance, thus enabling the low-power operation.

In the descriptions from the first implementation to the eighth implementation, the light emitting display device may have a bank-less structure, in which the bank for defining the emission area by covering the circumferential edges of the anode electrode ANO is not formed. For example, the bank may be an insulating layer for defining the emission area by covering the circumferential edges of the anode electrode ANO to expose the middle portion of the anode electrode ANO. The bank may also be referred to as a pixel defining layer. In some implementations, the light emitting display device according to the present disclosure may not have a bank at all. However, implementations are not limited thereto, and a bank may be disposed at the upper side and lower side of the pixel where the driving element is disposed, with the exceptions of the left side and the right side of the pixel. Further, for the case of having bank surrounding the pixel, the structure of implementations described in the present disclosure may be applied. Implementations of the present disclosure have been mainly described in a bankless structure that may be advantageous for low-power operation and may ensure the maximum aperture ratio.

According to an aspect of the present technique, a light emitting display device according to the present disclosure comprises: a substrate, a plurality of pixels, a first planarization layer, a second planarization layer, an anode electrode, an emission layer and a cathode electrode. The plurality of pixels is arranged on the substrate. Each of the pixels has an emission area and a non-emission area. The first planarization layer is disposed at or in the non-emission area with a first refractive index on the substrate. The second planarization is disposed at or in the emission area with a second refractive index higher than the first refractive index. The second planarization layer is extruded upward from the first planarization layer. The anode electrode is disposed on the second planarization layer within the emission area. The emission layer is disposed on the anode electrode, the first planarization layer and the second planarization layer. The cathode electrode is disposed on the emission layer. In one example, the second planarization layer may not be disposed horizontally over the first planarization layer and/or the second planarization layer may not be disposed on an upper surface of the first planarization layer, and/or the first planarization layer may not extend into the emission area i.e. may be limited only in or at the non-emission area, and/or at least one of an upper surface and a bottom surface of the second planarization layer may not extend into the non-emission area i.e. may be limited only in or at the emission area.

In an exemplary embodiment, the emission layer covers an upper surface of the first planarization layer, a sidewall (may also be referred to as a side surface hereinafter or in the present disclosure) of the second planarization layer and an upper surface of the anode electrode. The cathode electrode is in surface contact with the emission layer.

In an exemplary embodiment, the light emitting display device further comprises: a color filter disposed under the first planarization layer and the second planarization layer on the substrate; and a driving element layer disposed under the color filter on the substrate.

In an exemplary embodiment, the second planarization layer includes: a protrusion bottom point located at a (vertical) height same with an upper surface of the first planarization layer; a protrusion top point located at an upper surface of the second planarization layer; and a sidewall connecting the protrusion bottom point to the protrusion top point. A protrusion angle between the sidewall and the upper surface of the first planarization layer has any one angle in range of 50 degree to 80 degree. The protrusion angle may face the second planarization layer and/or the anode electrode and/or the emission area. The height in the present disclosure may be measured in a direction perpendicular to the substrate or perpendicular to the upper surface of the substrate.

In an exemplary embodiment, the first planarization layer and the second planarization layer contact each other at an interface. The interface includes: an interface top point contacting an upper surface of the first planarization layer, for example the interface top point may be a point at which an upper surface of the first planarization layer contacts the second planarization layer; and an interface bottom point where a bottom surface of the first planarization layer contacts a bottom surface of the second planarization layer. An inclination angle of the interface has any one angle in a range of 30 degree to 90 degree. The inclination angle may face the first planarization layer and/or face away from the anode electrode and/or may face the non-emission area. The inclination angle and the protrusion angle may face opposite direction or may face away from each other.

In an exemplary embodiment, the interface bottom point is disposed at a first point where a (virtual/imaginary) vertical line or perpendicular from the protrusion bottom point to the bottom surface of the second planarization layer meets the second planarization layer, or at a position apart from the first point to the first planarization layer with a predetermined distance, for example at a second point spaced apart from the first point in a direction towards the first planarization layer and/or in a direction towards the non-emission area and/or in a direction away from the emission area.

In an exemplary embodiment, a sidewall inclination direction (i.e. inclination direction of the sidewall with respect to a direction moving away from the substrate or when moving from the substrate towards the anode and/or cathode electrodes) of the second planarization layer is different from an interface inclination direction (i.e. inclination direction of the interface with respect to a direction moving away from the substrate or when moving from the substrate towards the anode and/or cathode electrodes), or the sidewall is inclined towards a first direction that is opposite to a second direction towards which the interface is inclined.

In an exemplary embodiment, the light emitting display device further comprises at least one slit first formed at or in the second planarization layer. The slit may be understood as a groove or indentation formed at or in the second planarization layer thereby making the second planarization layer have a shape (in vertical cross-section with respect to the substrate) having two crests divided by the slit/groove/indentation. The number of slits may be more than one, and each slit may then divide two adjacent crests which may also be thus more than two in total.

In an example, the anode electrode is disposed except an area where the at least one slit is disposed, or the anode electrode is not disposed at or in an area where the at least one slit is disposed. The anode electrode may not extend into the slit.

In an exemplary embodiment, the at least one slit exposes an upper surface of the first planarization layer, and/or the at least one slit may be vertically aligned with the first planarization layer.

In an exemplary embodiment, the at least one slit includes a plurality of slits arrayed with a predetermined interval within the pixel, or wherein the at least one slit includes a plurality of slits arranged at predetermined intervals within each of the plurality of pixels in a plan view.

In an exemplary embodiment, the second planarization layer is disposed between the slit and the first planarization layer, or wherein the second planarization layer is disposed between the at least one slit and the first planarization layer in a cross-section view.

In an exemplary embodiment, one pixel (say a first pixel) of the plurality of pixels includes: the first planarization layer disposed at or in the non-emission area except the emission area with a first thickness; and the second planarization layer disposed at or in the emission area except the non-emission area. The first planarization layer surrounds the second planarization layer.

In an exemplary embodiment, a first pixel among the plurality of pixels includes: the first planarization layer disposed with a first thickness at or in the non-emission area and not disposed at the emission area; and the second planarization layer disposed at or in the emission area and not disposed at the non-emission area, and wherein the first planarization layer surrounds the second planarization layer.

In an exemplary embodiment, a second pixel different from the first pixel includes: the first planarization layer disposed at or in the emission area and the non-emission area; and the second planarization layer disposed at or in the emission area except the non-emission area on the first planarization layer or the second planarization layer disposed at or in the emission area and not disposed at or in the non-emission area on the first planarization layer.

In an exemplary embodiment, one pixel or a first pixel of the plurality of pixels includes: the first planarization layer disposed at or in the non-emission area except the emission area with a first thickness or the first planarization layer disposed with a first thickness at or in the non-emission area and not disposed at or in the emission area; and the second planarization layer covering the first planarization layer at or in the non-emission area, and having a second thickness thicker than the first thickness at or in the emission area. The first planarization layer surrounds the second planarization layer.

In an exemplary embodiment, a second pixel different from the first pixel includes: the first planarization layer disposed at or in the emission area and the non-emission area; and the second planarization layer disposed on the first planarization layer at or in the emission area and the non-emission area, and having a protrusion portion at or in the emission area except the non-emission area.

In another aspect of the present technique, a light emitting display device is presented, comprising: a substrate; a plurality of pixels arranged on the substrate, each of the pixels having an emission area and a non-emission area; a first planarization layer with a first refractive index in the non-emission area, wherein an upper surface of the first planarization layer is at a first height; a second planarization layer with a second refractive index in the emission area, the second refractive index higher than the first refractive index, wherein an upper surface of the second planarization layer is at a second height greater than the first height; an anode electrode disposed on the second planarization layer within the emission area; an emission layer on the anode electrode, the first planarization layer, and the second planarization layer; and a cathode electrode on the emission layer.

The various implementations, i.e. exemplary embodiments described above can be combined to provide further implementations/exemplary embodiments.

These and other changes can be made to the implementations in light of the above-detailed description. In general, in the following claims, the terms used should not be construed to limit the claims to the specific implementations disclosed in the specification and the claims, but should be construed to include all possible implementations along with the full scope of equivalents to which such claims are entitled. Accordingly, the claims are not limited by the disclosure.

**Claims**

1.  A light emitting display device comprising:

    a substrate (110);
    a plurality of pixels (P) arranged on the substrate (110), each of the pixels (P) having an emission area (EA) and a non-emission area (NEA);
    a first planarization layer (PL1) disposed at the non-emission area (NEA) and having a first refractive index;
    a second planarization layer (PL2) disposed at the emission area (EA) and having a second refractive index higher than the first refractive index, the second planarization layer (PL2) extruded upward from the first planarization layer (PL1);
    an anode electrode (ANO) disposed on the second planarization layer (PL2) within the emission area (EA);
    an emission layer (EL) on the anode electrode (ANO), the first planarization layer (PL1), and the second planarization layer (PL2); and
    a cathode electrode (CAT) on the emission layer (EL).

2.  The light emitting display device according to claim 1, wherein the emission layer (EL) covers an upper surface of the first planarization layer (PL1), a sidewall of the second planarization layer (PL2) and an upper surface of the anode electrode (ANO), and
    wherein the cathode electrode (CAT) is in surface contact with the emission layer (EL).

3.  The light emitting display device according to claim 1 or 2, further comprising:

    a color filter (CF) disposed under the first planarization layer (PL1) and the second planarization layer (PL2) on the substrate (110); and
    a driving element layer disposed under the color filter (CF) on the substrate (110).

4.  The light emitting display device according to any one of the preceding claims, wherein the second planarization layer (PL2) includes a sidewall that extends from a protrusion bottom point (RB) to a protrusion top point (RT),

    wherein the protrusion bottom point (RB) is located at a same height as an upper surface of the first planarization layer (PL1),
    wherein the protrusion top point (RT) is located at an upper surface of the second planarization layer (PL2); and
    wherein a protrusion angle between the sidewall and the upper surface of the first planarization layer (PL1) is in a range of 50 degrees to 80 degrees.

5.  The light emitting display device according to any one of the preceding claims, wherein the first planarization layer (PL1) and the second planarization layer (PL2) contact each other at an interface (PLa),

    wherein the interface (PLa) extends from an interface bottom point (BB) to an interface top point (BT),
    wherein the interface top point (BT) is located at an upper surface of the first planarization layer (PL1),
    wherein the interface bottom point (BB) is located where a bottom surface of the first planarization layer (PL1) contacts a bottom surface of the second planarization layer (PL2), and
    wherein an inclination angle of the interface (PLa) is in a range of 30 degrees to 90 degrees.

6.  The light emitting display device according to claim 5 when depending on claim 4, wherein the interface bottom point (BB) is disposed at:

    (i) a first point where a vertical line from the protrusion bottom point (RB) to the bottom surface of the second planarization layer (PL2) meets the second planarization layer (PL2), or
    (ii) a second point spaced apart from the first point in a direction towards the first planarization layer (PL1).

7.  The light emitting display device according to claim 5 when depending on claim 4, or according to claim 6, wherein the sidewall is inclined towards a first direction that is opposite to a second direction towards which the interface (PLa) is inclined.

8.  The light emitting display device according to any one of the preceding claims, further comprising:
    at least one slit (SLT) formed at the second planarization layer (PL2).

9. The light emitting display device according to claim 8, wherein the anode electrode (ANO) is not disposed in an area where the at least one slit (SLT) is disposed; and/or
wherein the at least one slit (SLT) exposes an upper surface of the first planarization layer (PL1).

10. The light emitting display device according to claim 8 or 9, wherein the at least one slit includes a plurality of slits (SLT) arranged at predetermined intervals within each of the plurality of pixels (P) in a plan view.

11. The light emitting display device according to any one of claims 8 to 10, wherein the second planarization layer (PL2) is disposed between the at least one slit (SLT) and the first planarization layer (PL1) in a cross-section view.

12. The light emitting display device according to any one of the preceding claims, wherein a first pixel among the plurality of pixels (P) includes:

the first planarization layer (PL1) disposed with a first thickness at the non-emission area (NEA) and not disposed at the emission area (EA); and
the second planarization layer (PL2) disposed at the emission area (EA) and not disposed at the non-emission area (NEA), and
wherein the first planarization layer (PL1) surrounds the second planarization layer (PL2).

13. The light emitting display device according to claim 12, wherein a second pixel different from the first pixel includes:

the first planarization layer (PL1) disposed at the emission area (EA) and the non-emission area (NEA); and
the second planarization layer (PL2) disposed at the emission area (EA) and not disposed at the non-emission area (NEA) on the first planarization layer (PL1).

14. The light emitting display device according to any one of claims 1 to 11, wherein a first pixel among the plurality of pixels (P) includes:

the first planarization layer (PL1) disposed with a first thickness at the non-emission area (NEA) and not disposed at the emission area (EA); and
the second planarization layer (PL2) covering the first planarization layer (PL1) at the non-emission area (NEA), and having a second thickness thicker than the first thickness at the emission area (EA),
wherein the first planarization layer (PL1) surrounds the second planarization layer (PL2).

15. The light emitting display device according to claim 14, wherein a second pixel different from the first pixel includes:

the first planarization layer (PL1) disposed at the emission area (EA) and the non-emission area (NEA); and
the second planarization layer (PL2) disposed on the first planarization layer (PL1) at the emission area and the non-emission area (NEA), and having a protrusion portion disposed at the emission area (EA) and not disposed at the non-emission area (NEA).

# FIG. 1

# FIG. 2

# FIG. 3

# FIG. 4

# FIG. 5

II-II'

# FIG. 6

II-II'

NEA | EA | NEA

OLE

MR | CAT EL ANO | ③ | θ

θ'

PL2 | PL1 | CF | PAS | IL | GI | 110

PL

Z
X ← ⊙ Y

# FIG. 7

II-II'

NEA | EA | NEA

OLE

MR | CAT EL ANO | ④

θ

θ'

H | R | CF | PAS | IL | GI | 110

PL2 | PL1

PL

Z
X ← ⊙ Y

# FIG. 8

II-II'

# FIG. 9

# FIG. 10

# FIG. 11

II-II'

# FIG. 12

# FIG. 13

P(RP)

NEA    EA    NEA    EA    NEA

OLE

MR

CAT  EL  ANO

SLT

PL2
PL1 } PL

III                                                          III'

CF   PAS   IL  GI  110

# FIG. 14

P(RP)

NEA     EA     NEA     EA     NEA

OLE

CAT   EL   ANO

MR

SLT

PL2  
PL1 } PL

III                             III'

PL1   CF   PAS   IL   GI   110

# FIG. 15

EP 4 770 372 A1

# FIG. 16

NEA  EA  NEA  EA  NEA  EA  NEA  EA  NEA

RP  WP  GP  BP

OLE
CAT EL ANO

MR

R
H  } PL2

IV  IV'

PL1  PL2  CFR  PL1  PL2  PL1  PL2  CFG  PAS  IL  GI  PL1  PL2  CFB  110

PL

EP 4 770 372 A1

Europäisches
Patentamt

European
Patent Office

Office européen
des brevets

# EUROPEAN SEARCH REPORT

**Application Number**

EP 25 21 4893

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/423072 A1 (CHOI HOWON [KR] ET AL) 19 December 2024 (2024-12-19) | 1-3 | INV. H10K59/124 H10K59/80 |
| Y | * paragraphs [0078] - [0160]; figure 3 * | 4,8-11 | |
| A | | 5-7, 12-15 | |
| | ----- | | |
| X | US 2024/180004 A1 (CHOI HOWON [KR] ET AL) 30 May 2024 (2024-05-30) * paragraphs [0108] - [0116]; figures 8,9 * | 1 | |
| | ----- | | |
| Y | US 2023/413634 A1 (LEE YOUNGWOOK [KR] ET AL) 21 December 2023 (2023-12-21) * paragraphs [0138] - [0162]; figures 7,8 * | 4,8-11 | |
| | ----- | | |

**TECHNICAL FIELDS SEARCHED (IPC)**

H10K

The present search report has been drawn up for all claims

| Place of search | Date of completion of the search | Examiner |
|---|---|---|
| The Hague | 16 April 2026 | Bakos, Tamás |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................

& : member of the same patent family, corresponding document

EPO FORM 1503 03.82 (P04C01)

**EP 4 770 372 A1**

## ANNEX TO THE EUROPEAN SEARCH REPORT
## ON EUROPEAN PATENT APPLICATION NO.

EP 25 21 4893

16-04-2026

| Patent document cited in search report | | Publication date | Patent family member(s) | | Publication date |
|---|---|---|---|---|---|
| US 2024423072 | A1 | 19-12-2024 | CN | 119173077 A | 20-12-2024 |
| | | | DE | 102024116981 A1 | 19-12-2024 |
| | | | KR | 20240177244 A | 27-12-2024 |
| | | | US | 2024423072 A1 | 19-12-2024 |
| US 2024180004 | A1 | 30-05-2024 | CN | 118076200 A | 24-05-2024 |
| | | | KR | 20240077107 A | 31-05-2024 |
| | | | US | 2024180004 A1 | 30-05-2024 |
| US 2023413634 | A1 | 21-12-2023 | CN | 117279432 A | 22-12-2023 |
| | | | KR | 20230173983 A | 27-12-2023 |
| | | | US | 2023413634 A1 | 21-12-2023 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240201445